(19) Europäisches Patentamt
European Patent Office
Office européen des brevets

(11) **EP 4 354 222 A1**

(12) **EUROPEAN PATENT APPLICATION**

(43) Date of publication:
**17.04.2024 Bulletin 2024/16**

(21) Application number: **22200726.2**

(22) Date of filing: **11.10.2022**

(51) International Patent Classification (IPC):
**G03F 7/00** (2006.01) **B29C 41/00** (2006.01)
**B29C 43/00** (2006.01) **B82Y 40/00** (2011.01)

(52) Cooperative Patent Classification (CPC):
**G03F 7/0002; B29C 41/003; B82Y 30/00;**
H01F 1/447

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Max-Planck-Gesellschaft zur Förderung der Wissenschaften e.V.
80539 München (DE)**

(72) Inventors:
• **KIM, Jae-Kang**
**70569 Stuttgart (DE)**
• **KRISHNA-SUBBAIAH, Nagaraj**
**70569 Stuttgart (DE)**
• **WU, Yingdan**
**70569 Stuttgart (DE)**
• **SITTI, Metin**
**70569 Stuttgart (DE)**

(74) Representative: **Manitz Finsterwald
Patent- und Rechtsanwaltspartnerschaft mbB
Martin-Greif-Strasse 1
80336 München (DE)**

(54) **METHOD OF ROLL-TO-ROLL (R2R) MANUFACTURING OF A 3D-PATTERNED MICROSTRUCTURE, USE OF A 3D-PATTERNED MICROSTRUCTURE, AND AN APPARATUS FOR MANUFACTURING A 3D-PATTERNED MICROSTRUCTURE**

(57) The present invention relates to a method of roll-to-roll (R2R) manufacturing of a 3D-patterned microstructure. Further, the present invention relates to a 3D-patterned microstructure obtained by the method. In addition, the present invention relates to a use of a 3D-patterned microstructure manufactured according to the method. Furthermore, the present invention relates to an apparatus for manufacturing a 3D-patterned microstructure, the apparatus being configured to carry out the method.

Fig. 11b

EP 4 354 222 A1

## Description

## Technical Field

The present invention relates to a method of roll-to-roll (R2R) manufacturing of a 3D-patterned microstructure. Further, the present invention relates to a 3D-patterned microstructure obtained by the method. In addition, the present invention relates to a use of a 3D-patterned microstructure manufactured according to the method. Furthermore, the present invention relates to an apparatus for manufacturing a 3D-patterned microstructure, the apparatus being configured to carry out the method.

## Background of the Invention

3D-patterned microstructures have superior performances over non-patterned smooth surfaces, for example in terms of wettability, adhesion and friction, self-cleaning performance, anti-fouling, drag-reduction, non-icing, anti-fogging, electrical conductivity, thermal conductivity, and optical reflection and refraction. A wide range of patterns are known in the state of the art, such as mushroom-shaped 3D microstructures, wedge-shaped 3D microstructures, and flap-shaped 3D microstructures, for superior performance in adhesion, friction and/or wettability. Notably, micropatterned surfaces have gained considerable attention as dry adhesives because of their remarkable adhesion and/or friction performance. Inspired by the fibrillar attachment system of insects and geckos, the underlying mechanism of adhesion is currently known as the principle of "contact splitting". Fibrillar attachment is a bio-inspired adhesion observed and commonly associated with gecko-inspired fibrillar surfaces. In geckos, the setae form attachments which can be established and broken repeatedly within milliseconds, characterized by little wear occurring between skin shedding bouts. Without being bound by theory, the highly branched nature of setae and their numerous, very small spatular tips provide increased contact area and enhance van der Waals adhesion as well as friction between them and the substratum, thereby increasing the "adhesion component" of friction and enhancing the frictional interaction between the animal and the surface (Anthony P. Russell et al, Integrative and Comparative Biology 2019, Vol. 59, No 1, pp. 101-116).

Apart from its common application as a microstructured adhesive, 3D-patterned microstructures have proven to exhibit multiple other properties, such as frictional (e.g., non-slip), gripping, closure, optical, air/fluid drag-controlling, antifouling, anti-fogging, super-wetting, thermally insulating/conducting, skin-adhesive/gripping, electrically insulating/conducting, and/or non-wetting properties. Also, 3D-patterned microstructure surfaces are used in actuator, sensor, flexible circuit, and/or flexible and/or structural battery. Depending on its application, the 3D-patterned microstructures are designed and optimized for required performance, such as high adhesion and low friction, high adhesion and high friction, low adhesion and high friction, and low adhesion and low friction.

Such custom-made 3D microstructures can be fabricated directly by various micromanufacturing techniques, such as 3D-microprinting using two photon polymerization, optical lithography with etching (e.g., deep reactive ion etching), microwedge machining, drawing-based manufacturing, micromilling, laser micromachining, stereolithography, electro discharge machining, and/or ultrasonic micromachining. As another approach, such microstructure masters can be manufactured by the mentioned micromanufacturing techniques and such masters can be replicated by benchtop, roll-to-roll, injection, and/or compression molding methods.

Roll-to-roll manufacturing or processing, also known as continuous roll-to-roll manufacturing or processing, web processing, reel-to-reel processing or R2R, is used in various technical fields, such as electronic devices, coating, printing (also referred to as "replication"), or performing other processes starting with a roll of a flexible material and re-reeling after the process to create an output roll. Currently, R2R printing is used in the manufacturing of complex 3D microstructures due to several advantages concerning the potential of product commercialization, such as large-scale, continuous and fast production, as well as cost-effectiveness.

For micropatterned dry adhesives applications, the majority of the materials to be micropatterned (also referred to as "structural material") are polydimethylsiloxane (PDMS) and/or polyurethane (PU), both of which cure by thermal crosslinking. This choice of material is mainly based on their suitable mechanical properties, such as low elastic modulus and high elongation at break, which impart good adhesion strength combined with high flexibility. However, when it comes to a continuous roll-to-roll (R2R) fabrication, the structural material must allow fast curing. Ultraviolet (UV)-curable resins, such as polyurethane acrylate (PUA), are promising candidates for this as they are characterized by much faster curing (seconds up to few minutes) compared to thermally cured systems (minutes up to few hours).

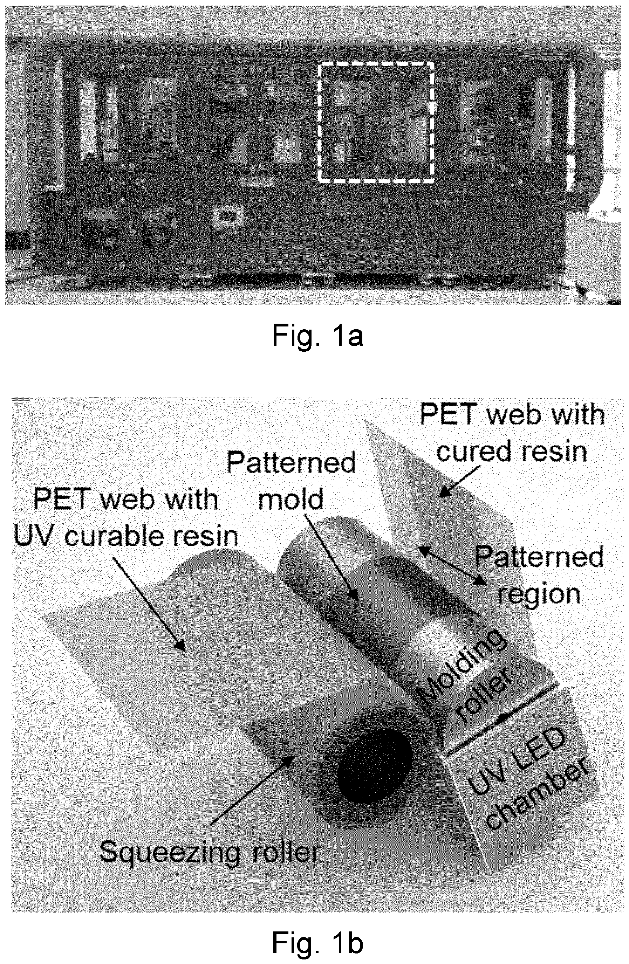

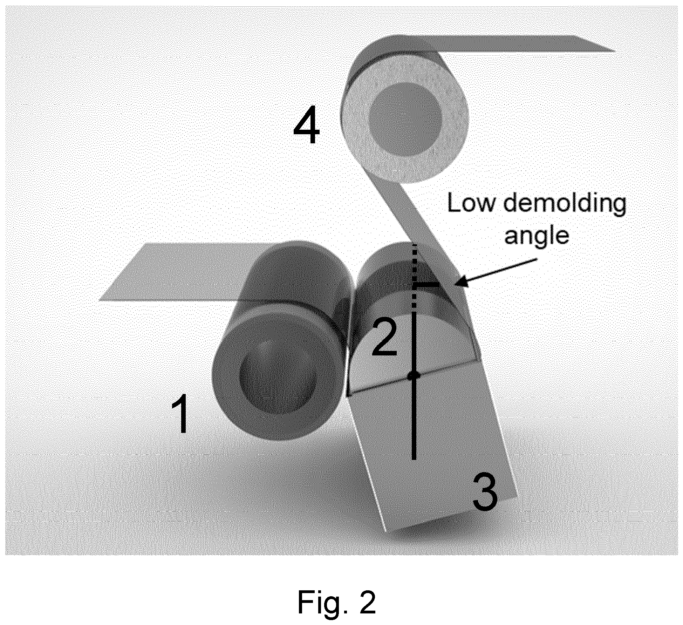

Fig. 1a depicts a roll-to-roll (R2R) manufacturing system using UV-curable materials (UV-R2R) mainly composed of four sections: i) UV-curable material and polyethylene terephthalate (PET) film feeding section; ii) pre-heating section; iii) molding-based replication (printing) section with printing unit highlighted in the figure; and iv) rewinding section. An insight into the printing unit of the molding-based replication (printing) section is illustrated in Fig. 1b. The printing unit comprises a pressing roller (also referred to as squeezing roller), a molding roller having a patterned mold on its surface, and a UV LED chamber attached to the molding roller. The UV-curable material situated on a base layer, such as a PET web, is forwarded via the pressing roller to the molding roller to be patterned and cured in the UV LED chamber. The resulting patterned surface is output by demolding from the molding roller using a demolding roller (Fig. 2). Typically, a conventional UV-R2R apparatus has a demolding angle of less than about 80 degrees; see Fig. 2.

Owing to the complex 3D (e.g., undercut) microstructures, a flexible mold is preferred for a reliable molding-based replication (printing) of such patterns. According to the state of the art, UV-R2R manufacturing of complex 3D-patterned microstructures using a flexible mold is associated with several drawbacks. On the one hand, specific performances of the microstructures as disclosed above, such as adhesive, non-wetting, and/or frictional properties, are poor compared to the benchtop-fabricated microstructures by conventional molding techniques. Without being bound by theory, this drawback is based on the incompatibility between the mold material and the structural material. On the other hand, another major drawback in UV-R2R manufacturing of microstructures is the poor lifetime of the flexible mold. In UV-R2R manufacturing systems of the state of the art, the flexible mold must be replaced in a frequent manner, therefore being associated with a low mold lifetime. A poor mold lifetime results in an impractical manufacturing of 3D microstructures due to a low cost- and time-efficiency.

In this context, there is still a need for a method of UV-R2R manufacturing of complex 3D microstructures with enhanced properties, such as adhesion, non-wetting, and/or frictional properties. There is also still a need for a method of UV-R2R manufacturing of diverse designs of complex 3D-patterned microstructures associated with various properties, such as adhesive, frictional (e.g., non-slip), gripping, closure, optical, air/fluid drag-control, antifouling, anti-fogging, super-wetting, thermally insulating/conductive, skin-adhesive/gripping, electrically insulating/conductive, and/or non-wetting. There is also still a need for a method of UV-R2R manufacturing systems applied for the large-scale production of 3D-patterned microstructures. There is also still a need for a cost-effective production method of complex 3D-patterned microstructures manufactured by UV-R2R systems. There is also still a need for a method of a UV-R2R manufacturing of complex 3D-patterned microstructures associated with enhanced flexible mold lifetime. There is also still a need for a method of a UV-R2R manufacturing of complex 3D-patterned microstructures associated with enhanced flexible mold repeatability. There is also a need for an apparatus for manufacturing complex 3D-patterned microstructures using a UV-R2R system satisfying at least one of the aforementioned needs.

**Summary of the Invention**

This need is satisfied by the respective independent patent claims. In particular, this need is satisfied by a method of roll-to-roll (R2R) manufacturing of a 3D-patterned microstructure according to claim 1, a 3D-patterned microstructure according to claim 14, a use of the 3D-patterned microstructure according to claim 15, and an apparatus for manufacturing a 3D-patterned microstructure according to claim 16. The dependent claims describe preferred embodiments of the invention.

As described herein and if of technical sense, details and advantages disclosed with respect to the method according to the first aspect of the invention also refer to the 3D-patterned microstructure according to the second aspect of the invention, to the use of a 3D-patterned microstructure according to the third aspect of the invention, and/or to the apparatus according to the fourth aspect of the invention, and vice versa.

According to the first aspect of the invention, the need is satisfied by a method of roll-to-roll (R2R) manufacturing of a 3D-patterned microstructure, the method comprising the steps of:

a) Providing a UV-curable material, the UV-curable material being castable;
b) Providing a mold layer comprising a microstructured mold top layer, the microstructured mold top layer being flexible;
c) Filling at least one part of the microstructured mold top layer with the UV-curable material, thereby providing a raw casting of the mold layer, the raw casting comprising the UV-curable material;
d) Subjecting the raw casting to a first curing step at a UV intensity of 10,000 mW/cm$^2$ or less, thereby providing a partially cured casting having a microstructured surface, wherein at least one part of the microstructured surface is not cured;
e) Removing the partially cured casting from the mold layer, thereby providing a removed partially cured casting;
f) Subjecting the removed partially cured casting to a second curing step, thereby providing a fully cured casting having a microstructured surface, wherein a total of the microstructured surface is cured.

According to the second aspect of the invention, the need is satisfied by a 3D-patterned microstructure obtained by the method according to the first aspect of the invention.

According to the third aspect of the invention, the need is satisfied by a use of a 3D-patterned microstructure manufactured according to the first aspect of the invention as at least one of a synthetic dry adhesive comprising a tape, a biomimetic adhesive comprising a gecko-inspired adhesive, a high gripping tape or surface, a non-slip tape or surface, a skin/tissue-adhesive tape or surface, a skin/tissue-gripping tape or surface, a closure tape or surface, a non-wetting tape or surface, a liquid-repellent tape or surface, a liquid-repellent adhesive tape or surface, a self-cleaning tape or surface, an anti-reflection coating, a drag reduction coating, an anti-fouling coating, an anti-fogging coating, a non-icing coating, a flexible electronic device, an optical device, a ciliated actuator device, an actuator device, a sensor device, a structured flexible battery, a solar cell layer, and/or a robotic device.

According to the fourth aspect of the invention, the need is satisfied by an apparatus for manufacturing a 3D-patterned microstructure, the apparatus being configured to carry out a method according to the first aspect of the invention, the apparatus being a printing unit of an R2R UV-curing manufacturing system, comprising:

a pressing roller, a molding roller comprising a mold layer on an outer surface of the molding roller, and a demolding roller arranged in a series one after another;

a first UV curing system attached to the molding roller and being configured to carry out a first curing step at a UV intensity of 10,000 mW/cm$^2$ or less;

a second UV curing system being attached to the demolding roller, or being arranged after the demolding roller, the second UV curing system being configured to carry out a second curing step;

the pressing roller and the molding roller being arranged to one another in a distance configured to press a UV-curable material onto the mold layer with a pressure of 1 MPa or more; and

the molding roller and the demolding roller being arranged to one another in an angle configured to provide a demolding angle of at least 80 degrees, preferably 90 degrees.

**Brief Description of the Drawings**

The invention will be explained in detail in the following by means of embodiments and with reference to the drawings in which are shown:

Fig. 1a    Front view of a roll-to-roll (R2R) manufacturing system using UV-curable material (UV-R2R). The highlighted region represents the printing unit of the molding-based replication (printing) section.

Fig. 1b    Schematic view of the printing unit of the molding-based replication (printing) section.

Fig. 2    Schematic illustration of a printing unit according to a UV-R2R setup of the state of the art, comprising a pressing roller (1), a molding roller (2) attached to a UV chamber (3), and a demolding roller (4). The circumferential axis of the molding roller is shown as vertical continuous line. A continuing of the circumferential axis of the molding roller in a direction towards the demolding roller is shown in dashed line. The continuous horizontal line on the molding roller is required for defining the demolding angle.

Fig. 3    Schematic illustration of a printing unit according to a UV-R2R setup of the present invention, comprising a pressing roller (10), a molding roller (20) attached to a UV chamber (30), a demolding roller (40), and a UV system arranged for a second curing step (50). The circumferential axis of the molding roller is shown as vertical continuous line. A continuing of the circumferential axis of the molding roller in a direction towards the demolding roller is shown in dashed line. The continuous horizontal line on the molding roller is required for defining the demolding angle.

Fig. 4a    Graph illustrating the effect of the UV curing time during the partial curing step on the surface roughness (Ra; [nm]) of a fully cured PUA microstructure obtained after second curing step f). The surface roughness values are plotted against the curing time (min) with respect to five (5) samples of fully cured PUs, each one of them having a different partial curing time of 2 min, 2.5 min, 3 min, 5 min, and 10 min, respectively.

Fig. 4b    Graph illustrating the effect of the UV curing time during the partial curing step on the pull-off force (POF; [mN]) of a fully cured PUA microstructure obtained after second curing step f). The pull-off force values are plotted against the curing time (min) with respect to five (5) samples of fully cured PUs, each one of them having a different partial curing time of 2 min, 2.5 min, 3 min, 5 min, and 10 min, respectively.

Fig. 5    A schematic side view of a mold layer used in a preferred embodiment of the present invention, the mold layer comprising a flexible mold top layer comprising PVS, a bottom layer comprising a PET sheet, and three intermediate layers being glue, a cloth wipe and a double sided tape (the glue is not shown in the Figure).

Fig. 6a    A schematic side view of a tip of a microstructure according to the present invention. The tip dimensions "tip upper diameter", "tip lower diameter", and "tip height" correspond to the cavity dimensions "cavity lower diameter", "cavity upper diameter", and "cavity depth" of the microstructured mold top layer.

Fig. 6b    SEM image of a microstructured and fully cured casting made of PUA obtained according to the present invention from a top view.

Fig. 6c    SEM image of a microstructured and fully cured casting made of PUA obtained according to the present invention from an angled view.

Fig. 7a    Cross-sectional SEM image of a PVS mold top layer having truncated cone-shaped cavities.

Fig. 7b    Schematic side view of mold having mushroom-shaped cavities.

Fig. 7c    SEM images from an angled view of microstructures having mushroomshaped tips molded from PFPE molds having mushroom-shaped cavities.

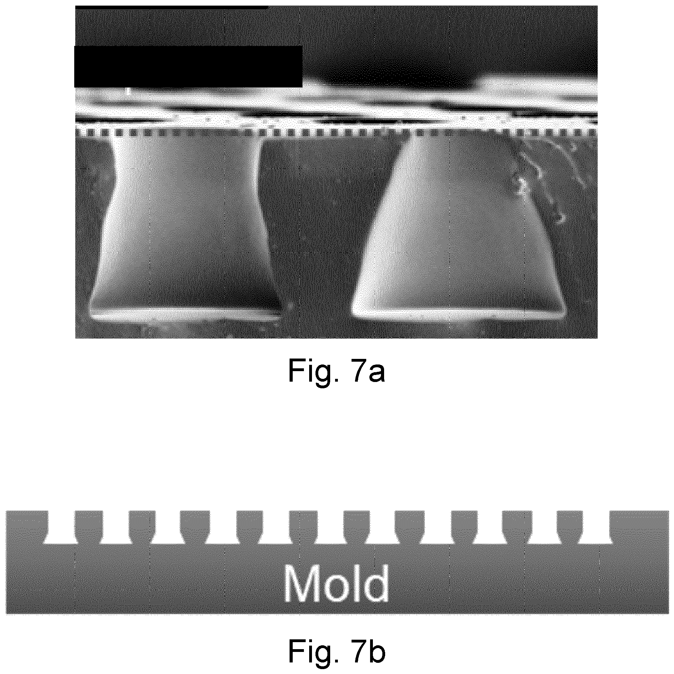

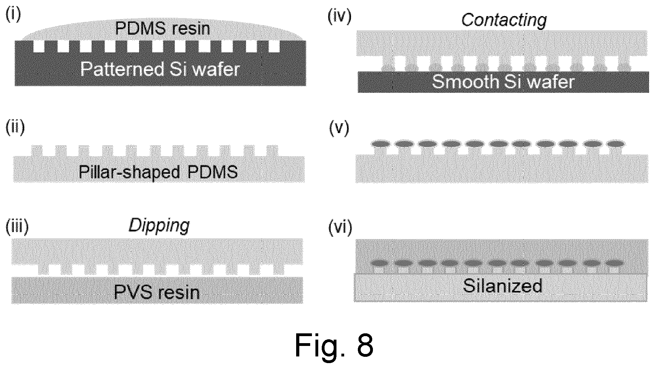

Fig. 8    Manufacturing steps for making a mold top layer patterned with a microstructure by an inking process. (i) PDMS resin is poured onto the pillarpatterned silicon wafer. (ii) The pillar-shaped microstructures are fabricated made of PDMS. (iii) The patterned PDMS is dipped into the PVS resin by its own weight before the resin is cured. (iv) The dipped PDMS sample is touched by a smooth silicon wafer and cured for 10 min. (v) The microstructures are formed on the PDMS backing layer. (vi) The structured PDMS sample is silanized and the PVS resin is poured onto the silanized PDMS sample. (vii) (see Fig. 7b) After demolding, the final patterned mold made of PVS is achieved.

Fig. 9    Optical microscope images representing the effects of the UV intensity and curing time on the mold repeatability at a UV wavelength of 365 nm.

Fig. 10    Effect of the squeeze pressure (determined by the gap between the squeezing (pressing) roller and the molding roller) on the microstructure formation.

Fig. 11a    SEM images of the printed PUA microstructures at molding cylce 1 and 1000, respectively, using a PVS mold top layer having micrometer-sized cavities being truncated cone-shaped.

Fig. 11b    SEM images of the printed PUA microstructures at molding cylce 1 and 1000, respectively, using a PVS mold top layer having micrometer-sized cavities being mushroom-shaped.

Fig. 11c    Pull-off force fo the printed structures molded at replication cycles 1 and 1000, respectively. Str#1 relates to the microstructures shown in Fig. 11a. Str#2 relates to the microstructures shown in Fig. 11b.

Fig. 12    SEM images of printed microstructures having mushroom-shaped tips at replication cylcle 1, 100, 200, and 600, respectively, molded from molds comprising a flexible PFPE mold top layer. Both top images on the right show SEM images of microstruces printed under the conventional UV-R2R conditions (see Comparative Example 1). Both bottom images on the right whon SEM images of microstruces printed under inventive UV-R2R conditions (see Example 1).

Fig. 13a    SEM image of 3D-patterned PUA microstructures printed according to the conventional UV-R2R system after 10 to 20 replication cycles.

Fig. 13b    SEM image of the top view of a damaged PVS mold used in the printing of 3D-patterned PUA microstrucutres according to the conventional UV-R2R system after 10 to 20 replication cycles.

Fig. 13c    SEM image of the cross-sectional view of a damaged PVS mold used in the printing of 3D-patterned PUA microstrucutres according to the conventional UV-R2R system after 10 to 20 replication cycles.

Fig. 14    Demonstration of the adhesive performamce of 3D-patterned PUA microstructures printed according to the present invention using a PVS mold with truncated cone-shaped cavtities.

**Detailed Description**

The method according to the first aspect of the present invention is intended for manufacturing a 3D-patterned microstructure by printing using an R2R system. Herein, the term "R2R printing" is also referred to as "R2R replication".

In the present invention, the UV-curable material acts as the structural material to be patterned during the UV-R2R printing process. Prior to a UV induced curing, thus before hardening, the UV-curable material is castable allowing a casting of the structural material at operating conditions, preferably of from -20 °C to 80 °C, preferably of from about -10 °C to about 50 °C, more preferably of from about 0 °C to about 40 °C, even more preferably of from about 5 °C to about 35 °C, even more preferably of from about 10 °C to about 30 °C, even more preferably of from about 15 °C to about 25 °C, and event more preferably of from about 21 °C to about 24 °C. The term "about" refers to a deviation of $\pm 0.05$ °C. The relative humidity during operating is preferably of from 35% to 50%, more preferably of from 40% to 45%.

In the present invention, the UV-curable material is preferably a UV-curable resin. A UV-curable resin is generally a resin that polymerizes and cures (i.e., hardens) in a short time (i.e., seconds to few hours, preferably to few minutes) by the energy of ultraviolet rays (UV) emitted from an ultraviolet irradiation device. In this context, the term "resin casting" may be used, being a general method of plastic casting where a mold is filled with a liquid synthetic resin, which then hardens.

A mold layer according to the present invention is a layer mounted on a surface of a molding roller in a printing unit of a UV-R2R apparatus, the layer being intended for printing a microstructured pattern onto/into the UV-curable material. Said mounting may be performed using a double-sided tape. The microstructured patterns are part of a mold top layer of the mold layer, i.e., the microstructured patterns belong to a top (i.e., uppermost) layer of the mold layer.

An important aspect of the present invention is that the microstructured mold top layer is flexible. Herein, the phrase "flexible mold layer" means that at least the microstructured mold top layer of the mold layer is flexible. An alternative expression is "flexible mold top layer" which does not exclude that at least another mold layer being situated below the mold top layer is flexible, as well. A flexible mold layer according to the present invention refers to a mold top layer comprising or consisting of a flexible polymer, preferably consisting of at least one type of a flexible polymers, even more preferably consisting of one type of flexible polymer. A sufficient flexibility of the mold top layer is required for a reliable replication of complex 3D microstructures. It is therefore preferred to use a flexible mold top layer in order to enhance the replication number of complex 3D microstructures.

The term "replication number" (also referred to as "replication cycle", "printing number", or "printing cycle") means the number/cycles of feasible replications of complex 3D microstructures characterized by low damage, low deformation, and/or low deterioration in uniformity and high-resolution replicating properties of the mold top layer. A high replication cycle is associated with a high lifetime of the flexible mold top layer, thereby referring to a high "mold repeatability".

The steps a) and b) are interchangeable, i.e., the present invention also relates to a method, wherein step a) is directed to providing a mold layer comprising a microstructured mold top layer, the microstructured mold top layer being flexible; while step b) is directed to providing a UV-curable material, the UV-curable material being castable.

In step c) of the method according to the first aspect of the present invention, a raw casting of the mold layer is provided. The term "raw casting" refers to the uncured and castable UV-curable material being poured onto the mold layer and filling at least one part of the microstructured mold top layer. The intended microstructured pattern is therefore not fully formed in the structural material, and not formed at all in case the mold layer was fully detached prior to curing. The micro-sized cavities (i.e., voids) forming the microstructured pattern of the mold top layer are at least partially filled with the UV-curable material.

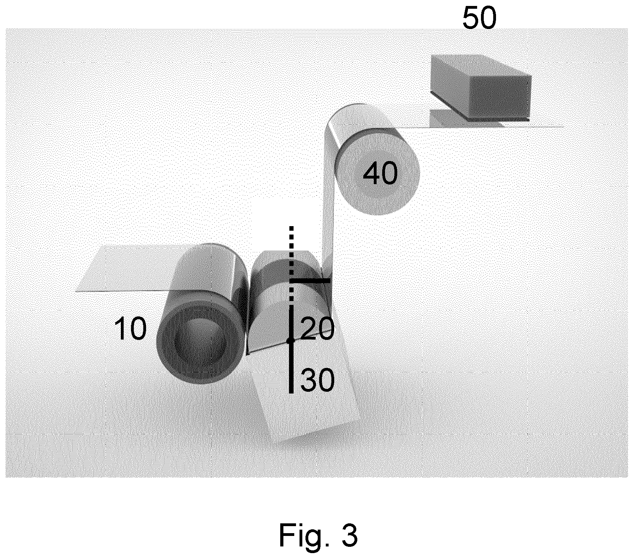

In the printing unit of a UV-R2R system, the UV-curable material is applied to a base layer, preferably a PET web, wound around a pressing roller (i.e., squeezing roller); see Fig. 3. Thereafter, the base layer comprising the UV-curable material is transferred from the pressing roller to the molding roller, wherein the distance between the pressing roller and the molding roller is configured to press the base layer comprising the UV-curable resin against the mold layer mounted on the molding roller. The distance is chosen to create a sufficient filling of the micro-sized cavities forming the microstructured pattern of the mold top layer by the UV-curable material.

The method according to the first aspect of the present invention is characterized by two curing steps, a first curing step d) and a second curing step f), wherein the first curing step d) is referred to a partial curing, and the second curing step f) is referred to a complete curing of the UV-curable material.

The curing steps may be performed using any UV curing system appropriate for UV-induced curing of the UV-curable material described herein. The UV curing system comprises a microwave powered UV curing system, UV-LED curing system, UV gas discharge lamp, UV lamp, UV LED lamp, UV flood lamp, UV hand lamp, UV curing chamber, and UV-LED curing chamber. The UV-LED curing system during the first curing step is preferably attached to the molding roller, or alternatively arranged at or around the molding roller in that a first curing of the UV-curable material is enabled. Also, the first curing step is preferably performed using a UV curing chamber, more preferably a UV-LED curing chamber. In a preferred embodiment, during the first curing step d), curing is performed using a UV-LED curing chamber attached to the molding roller. In another preferred embodiment, during the second curing step f), curing is performed using a UV hand lamp, or a UV-curing chamber attached to the demolding roller or arranged after the demolding roller.

In step d) of the method according to the first aspect of the present invention, the raw casting is subjected to a first curing step at a UV intensity of 10,000 mW/cm$^2$ or less. The term "raw casting" refers to an uncured casting comprising the UV-curable material which is filled into the microstructured mold top layer. Step d) comprises two important factors for the present invention, namely the first factor of applying a UV intensity of 10,000 mW/cm$^2$ or less, and the second factor of partial curing of the raw casting comprising the UV-curable material during the first curing step d). Although the advantages of the present invention may be obtained with one factor only, the advantages may be more easily obtained, in particular to a greater extent, with both factors. Both factors are typically interconnected to some extent so that one factor has at least a small influence on the other factor. For example, application of a higher UV intensity may decrease the time for completing/reaching partial curing of the raw casting comprising the UV-curable material (i.e., partial curing time), and vice versa. However, it is shown in the present invention that the partial curing is not exclusively or necessarily dependent of the UV intensity applied so that appropriate adjustment of both factors is important. The partial curing may be determined as described further below.

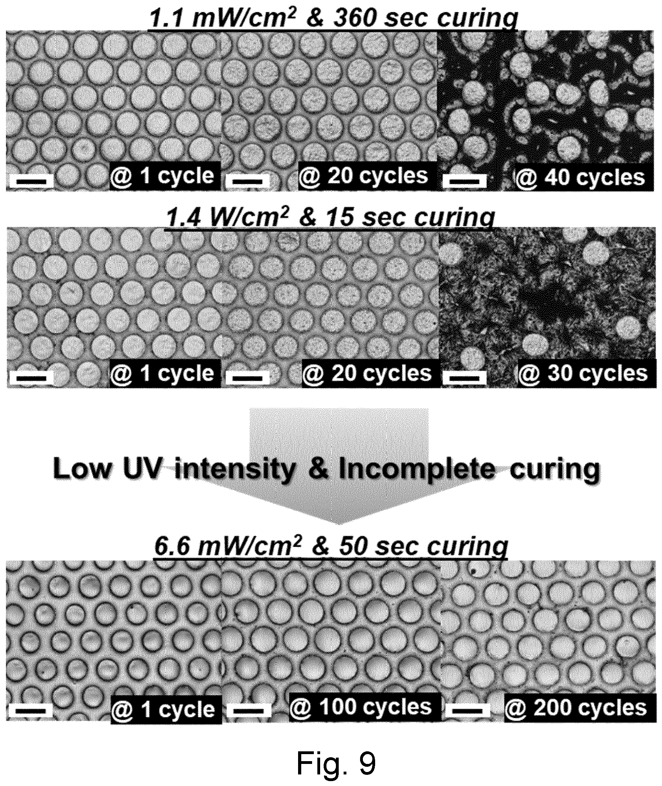

Combination of applying a UV intensity of 10,000 mW/cm$^2$ or less, and completing/reaching the partial curing of a raw casting comprising the UV-curable material is associated with the advantages of the present invention, in particular enhancing the flexible mold repeatability, and/or flexible mold lifetime. The effects of the UV intensity and the partial curing of the raw casting comprising the UV-curable resin during the first curing step is demonstrated by means of Example 2, Fig. 9 and is described in more detail further below.

The advantages of the present invention (such as increased flexible mold lifetime, and/or increased flexible mold repeatability) are significantly influenced by the partial curing (next to the applied UV intensity during the first curing step). In other words, the advantages of the present invention may be easily obtained for when the partial curing is complete and/or the partial curing time is reached. A (too) short partial curing time and/or an incomplete partial curing is associated with reduced advantages, such as reduced flexible mold lifetime, and/or reduced flexible mold repeatability. Also, a (too) short partial curing time is associated with an incomplete microstructure formation on the casting surface comprising the UV-curable material, for example resulting in a poor adhesive performance of the printed 3D-patterned microstructure. Similarly, a (too) long partial curing time and/or reaching a curing level beyond being partially cured is also associated with reduced advantages, such as reduced flexible mold lifetime, and/or reduced flexible mold repeatability.

The partial curing is influenced by the UV intensity applied, the UV wavelength, the PET web feeding rate, and/or the composition of both the raw casting comprising the UV-curable material and the mold layer, in particular the mold top layer. For example, a fast PET web feeding rate in a UV-R2R system may decrease the partial curing time, and vice versa. Also, using a flexible mold top layer particularly permeable to oxygen may increase the partial curing time (oxygen inhibition effect).

In the present invention, the expression "first curing step d)" or "first curing step" may also be referred to as a "partial curing" or "partial curing step". In step d), it is provided a partially cured casting, comprising a partially cured UV-curable material, exhibiting a microstructured surface. In other words, the surface of the partially cured casting is fully patterned by the microstructured cavities of the flexible mold top layer, i.e., a demolded partially cured casting shows a fully formed micropattern on a microscopic level. Additionally, the partially cured casting is also characterized by at least one part of its microstructured surface being uncured. In other words, the surface of a demolded partially cured casting is sticky and smoother on a nanoscopic and/or microscopic level. Even though the partially cured casting is fully patterned, the surface of the microstructures is smoother than a fully cured casting; see Fig. 9 and Example 2. Without being bound by theory, this is because the surface of the partially cured casting does not reflect all (nanometer-sized) details on a surface of the flexible mold layer, while the 3D-patterned micropattern is fully formed.

The time at which the first curing step d) is completed (i.e., partial curing time) may therefore be observed on a microscopic level as described above, or may be determined using surface roughness analysis and/or pull-off force analysis.

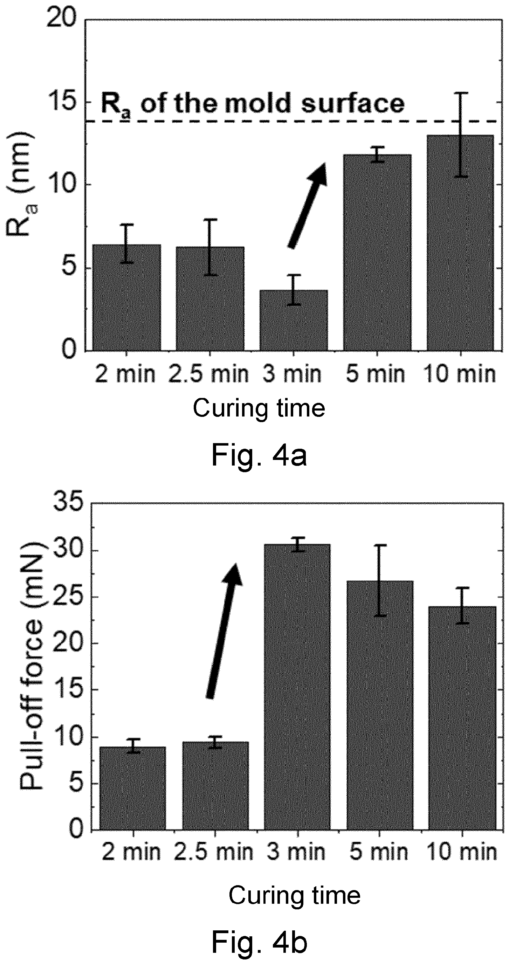

The required curing time for complete partial curing may be determined using surface roughness analysis; see Fig. 4a. A lower surface roughness (Ra; [nm]) is associated with a smoother surface of a material.

A fully cured casting comprising a fully cured UV-curable material obtained after the second curing step f) may have a high surface roughness Ra* when the partial curing was incomplete. This may be the case for when the partial curing was insufficient, and/or the partial curing time was (too) short. In some embodiments, this may be the case for when the time of partial curing in step d) is 1 minute or less, preferably 1.5 minutes or less, more preferably 2 minutes or less, even more preferably 2.5 minutes or less, most preferably below 3 minutes, depending on the applied UV-curable resin and UV light properties (UV wavelength, UV intensity); see Example 3.

A fully cured casting comprising a fully cured UV-curable material obtained after the second curing step f) may have a surface roughness Ra*** higher than Ra* when during the first curing step d) a curing level beyond being partially cured was reached. This may the case for when the curing level is beyond completion of partial curing, and/or the partial curing time was (too) long. In some embodiments, this may be the case for when the time of partial curing in step d) is 2 minutes or more, preferably 2.5 minutes or more, more preferably 3 minutes or more, even more preferably 3.5 minutes or more, even more preferably 5 minutes or more, even more preferably 10 minutes or more depending on the applied UV-curable resin and UV light properties (UV wavelength, UV intensity); see Example 3.

A fully cured casting comprising a fully cured UV-curable material obtained after the second curing step f) may have a surface roughness Ra** lower than each one of Ra* and Ra*** when the partial curing was complete. In some embodiments, this may be the case for when the time of partial curing in step d) lies in the range of from 1.5 minutes to 4 minutes, preferably of from 2 minutes to 3.5 minutes, even more preferably of from 2.5 minutes to 3.5 minutes, even more preferably 3 minutes, depending on the applied UV-curable resin and UV light properties (UV wavelength, UV intensity); see Example 3.

In view of the aforementioned, some embodiments refer to a ratio between the surface roughness values Ra* Ra**, and Ra*** which may be determined as:

$$Ra* > Ra** < Ra***,$$

wherein

Ra* = surface roughness of a fully cured casting comprising a fully cured UV-curable material when partial curing in step d) was incomplete;

Ra** = surface roughness of a fully cured casting comprising a fully cured UV-curable material when partial curing in step d) was complete;

Ra*** = surface roughness of a fully cured casting comprising a fully cured UV-curable material when first curing in step d) reached a curing level beyond being partially cured; and

preferably wherein Ra*** $\geq$ Ra* more preferably wherein Ra*** > Ra*

In a preferred embodiment, the surface roughness value Ra* is higher than the surface roughness value Ra**. In another preferred embodiment, the surface roughness value Ra*** is higher than the surface roughness value Ra**. In another preferred embodiment, the surface roughness values Ra* and Ra*** are each be higher than the surface roughness value Ra**.

In a preferred embodiment, the surface roughness value Ra** is lower than the surface roughness value Ra*. In another preferred embodiment, the surface roughness value Ra** is lower than the surface roughness value Ra***. In another preferred embodiment, the surface roughness value Ra** is lower than each one of the surface roughness values Ra* and Ra***.

In one embodiment, the surface roughness value Ra*** is higher than the surface roughness value Ra*. In another embodiment, the surface roughness value Ra*** is equal to the surface roughness value Ra*. In another embodiment, the surface roughness value Ra*** is lower than the surface roughness value Ra*.

The required curing time for complete partial curing may also be determined using pull-off force analysis; see Fig. 4b. A higher pull-off force (POF; [mN]) is for example associated with a higher adhesive performance of a material.

A fully cured casting comprising a fully cured UV-curable material obtained after the second curing step f) may have a low pull-off force POF* when the partial curing was incomplete. This may be the case for when the partial curing was insufficient, and/or the partial curing time was (too) short. In some embodiments, this may be the case for when the time of partial curing in step d) is 1 minute or less, preferably 1.5 minutes or less, more preferably 2 minutes or less, even more preferably 2.5 minutes or less, most preferably below 3 minutes, depending on the applied UV-curable resin and UV light properties (UV wavelength, UV intensity); see Example 4.

A fully cured casting comprising a fully cured UV-curable material obtained after the second curing step f) may have a pull-off force POF*** higher than POF* when during the first curing step d) a curing level beyond being partially cured was reached. This may the case for when the curing level is beyond completion of partial curing, and/or the partial curing time was (too) long. In some embodiments, this may be the case for when the time of partial curing in step d) is 2 minutes or more, preferably 2.5 minutes or more, more preferably 3 minutes or more, even more preferably 3.5 minutes or more, even more preferably 5 minutes or more, even more preferably 10 minutes or more depending on the applied UV-curable resin and UV light properties (UV wavelength, UV intensity); see Example 4.

A fully cured casting comprising a fully cured UV-curable material obtained after the second curing step f) may have a pull-off force POF** higher than each one of POF* and POF*** when the partial curing was complete. In some embodiments, this may be the case for when the time of partial curing in step d) lies in the range of from 1.5 minutes to 4 minutes, preferably of from 2 minutes to 3.5 minutes, even more preferably of from 2.5 minutes to 3.5 minutes, even more preferably 3 minutes, depending on the applied UV-curable resin and UV light properties (UV wavelength, UV intensity); see Example 4.

In view of the aforementioned, some embodiments refer to a ratio between the pull-off force values POF*, POF**, and POF*** which may be determined as:

$$POF^* < POF^{**} > POF^{***},$$

wherein

POF* = pull-off force of a fully cured casting comprising a fully cured UV-curable material when partial curing in step d) was incomplete;

POF** = pull-off force of a fully cured casting comprising a fully cured UV-curable material when partial curing in step d) was complete;

POF*** = pull-off force of a fully cured casting comprising a fully cured UV-curable material when first curing in step d) reached a level beyond being partially curing; and

preferably wherein POF*** > POF*.

In a preferred embodiment, the pull-off force value POF** is higher than the pull-off force value POF*. In another preferred embodiment, the pull-off force value POF** is higher than the pull-off force value POF***. In another preferred embodiment, the pull-off force value POF** is higher than each one of the pull-off force values POF* and POF***.

In a preferred embodiment, the pull-off force value POF* is lower than the pull-off force value POF**. In another preferred embodiment, the pull-off force value POF*** is lower than the pull-off force value POF**. In another preferred embodiment, each one of the pull-off force values POF* and POF*** is lower than the pull-off force value POF**.

In one embodiment, the pull-off force value POF*** is higher than the pull-off force value POF*. In another embodiment, the pull-off force value POF*** is equal to the pull-off force value POF*.

Step e) of the method according to the first aspect of the present invention is removing the partially cured casting from the mold layer, thereby providing a removed partially cured casting. The term "removing" may also be referred to as "demolding". Removing of the partially cured casting is performed using a demolding roller.

Step f) of the method according to the first aspect of the present invention is subjecting the removed partially cured casting to a second curing step, thereby providing a fully cured casting having a microstructured surface, wherein a total of the microstructured surface is cured.

Unlike the partially cured casting, the surface of the fully cured casting is completely cured, i.e., is not sticky, in addition to exhibiting the microstructured pattern obtained during the first curing step d). The term "sticky" as used herein refers to an uncured surface of a UV-curable material which is not fully hardened and is therefore at least liquid to some extent, preferably viscos. The term "sticky" as used herein does not refer to a potential adhesion property of the UV-curable material deriving from the patterned 3D microstructures.

In one embodiment, the UV-curable material has a Young's modulus of about 100 GPa or less, preferably about 50 GPa or less, 10 GPa or less, or 1 GPa or less. In a preferred embodiment, the UV-curable material has a Young's modulus of about 100 MPa or less. The term "about" with respect to the Young's modulus of the UV-curable material described herein is referred to a deviation of $\pm$ 0.05 MPa.

In a preferred embodiment, the UV-curable material has a Young's modulus in the range of from about 0.1 MPa to about 100 MPa, more preferably of about 90 MPa or less, more preferably of about 80 MPa or less, more preferably of 70 MPa or less, more preferably of about 60 MPa or less, more preferably of about 50 MPa or less, more preferably of about 40 MPa or less, more preferably of about 30 MPa or less, more preferably of about 20 MPa or less, and even more preferably of about 10 MPa or less.

In another preferred embodiment, the UV-curable material has a Young's modulus in the range of from about 1 MPa to about 10 MPa, more preferably from about 2 MPa to about 6 MPa, more preferably from about 2.5 MPa to about 5 MPa, more preferably of from about 2 MPa to about 4.5 MPa, more preferably from about 2 MPa to about 4 MPa, more preferably from about 2.5 MPa to about 3.5 MPa, and even more preferably from about 2.7 MPa to about 3.2 MPa.

In one embodiment, the UV-curable material has a Young's modulus of about 9.4 MPa. In a preferred embodiment, e UV-curable material has a Young's modulus of about 3.2 MPa. In another preferred embodiment, e UV-curable material has a Young's modulus of about 2.7 MPa. In another preferred embodiment, the UV-curable material has a Young's modulus of about 1.8 MPa. In a most preferred embodiment, the UV-curable material has a Young's modulus of about 3.2 MPa.

In one embodiment, the UV-curable material has an elongation at break value of about 900 % or less. The term "about" with respect to the Young's modulus of the UV-curable material described herein is referred to a deviation of ± 0.5 %.

In a preferred embodiment, the UV-curable material has an elongation at break value of about 800 % or less, more preferably of about 700 % or less, more preferably of about 600 % or less, more preferably of about 500 % or less, more preferably of about 400 % or less, more preferably of about 300 % or less, more preferably of about 250 % or less, and even more preferably of about 200 % or less.

In another preferred embodiment, the UV-curable material has an elongation at break value of about 900 % to about 10 %, preferably of from about 260 % to about 90 %, more preferably of from about 200 % to about 150 %, more preferably of from about 180 % to about 150 %, and even more preferably of from about 170 % to about 160 %.

In a preferred embodiment, the UV-curable material has an elongation at break value of about 250 %. In another preferred embodiment, the UV-curable material has an elongation at break value of about 166 %. In another preferred embodiment, the UV-curable material has an elongation at break value of about 165 %. In another preferred embodiment, the UV-curable material has an elongation at break value of about 93 %. In a most preferred embodiment, the UV-curable material has an elongation at break value of about 166 %.

The above listed ranges of the Young's modulus and elongation at break values of the UV-curable material enhances the technical effects of the present invention in that demolding of a partially cured casting may be performed more gently. The complex microstructures formed on the partially cured casting may thus be separated from the flexible mold with small to insignificant damages of the microstructures. In a similar manner, a certain demand of elasticity and/or stretchability of a UV-curable material as described herein is required for enhancing the lifetime and replication number of the flexible mold. Also, with regard to the application as adhesive, the above listed ranges of the Young's modulus and elongation at break values of the UV-curable material is associated with an enhanced adhesive performance of the printed 3D-microstructure.

In one embodiment, the UV-curable material comprises an acrylic resin, preferably wherein the acrylic resin is aliphatic. As used herein, the term "UV-curable material" refers to a structural material which cures upon UV irradiation, or a structural material which does not cure upon UV irradiation and thus requires the presence of a photoinitiator to do so. In the method according to the first aspect of the invention, those materials are desired which hardening is significantly inhibited by oxygen, which do not significantly cure after pausing UV irradiation, and/or which curing is not significantly accelerated by heat. The term "significant" relates to such an extent which would diminish the technical effects of the present invention.

In a preferred embodiment, the UV-curable material preferably comprises polyurethane acrylate (PUA), silicone, polyvinylsiloxane (PVS), perfluoropolyether (PFPE), polydimethyl siloxane (PDMS), synthetic rubber, natural rubber, liquid crystal elastomer, butyl rubber, biological elastomer, protein, shape memory polymer, conductive polymer, magnetorheological elastomer, zwitterionic polymer, styrene-ethylene-butylene-styrene (SEBS), foam elastomer, and/or composite polymer. Said composite material comprising micrometer or nanometer-sized particle, colloid, fiber, tube, sheet, wire, fabric, bubble, and/or clay. This list is not limited and also other suitable materials may be used as UV-curable material.

In a preferred embodiment, the UV-curable material is selected from the group consisting of polyurethane acrylate (PUA), silicone, polyvinylsiloxane (PVS), perfluoropolyether (PFPE), and/or polydimethyl siloxane (PDMS). In a more preferred embodiment, the UV-curable material is polyurethane acrylate (PUA). In particular, polyurethane acrylate (PUA) has been mainly used as the structural material because they it can be cured fast with superior and tunable mechanical properties.

In one embodiment, the UV-curable material does not comprise a material which continues curing after pausing UV irradiation. This may be the case for an epoxy resin. Therefore, in another embodiment, the UV-curable material does not comprise an epoxy resin.

In one embodiment, the UV-curable material further comprises a photoinitiator, preferably wherein the photoinitiator is present in an amount of from about 1 wt% to about 8 wt%, more preferably in an amount of from about 2 wt% to about 5 wt%, and even more preferably in an amount of from about 3 wt% to about 4 wt%, based on a total mass of the UV-curable material. The term "about" with respect to the amount of the photoinitiator described herein is referred to a deviation of ± 0.5 %.

In a preferred embodiment, the photoinitiator is present in an amount of about 3 wt%, based on a total mass of the UV-curable material.

In one embodiment, the photoinitiator is selected from the group consisting of 2-hydroxy-2-methylpropiophenone, and/or type I photoinitiator comprising 1-Hydroxycyclohexyl phenyl ketone, diphenyl(2,4,6-trimethylbenzoyl)phosphine oxide, and/or 4-Hydroxybenzophenone. In a preferred embodiment, at least one photoinitiator is used. In another preferred embodiment, at least two photoinitiators are used. In a preferred embodiment, one photoinitiator is used. In a preferred embodiment, two different photoinitiators are used.

The term "type I photoinitiator" described herein refers to "Norrish type I photoinitiator". Type I photoinitiator are typically compounds containing benzoyl groups. The carbonyl group of the photoinitiator absorbs a photon and is transformed into an excited state. Subsequent homolytic cleavage of the excited $\alpha$-carbon bond results in two radical fragments. For example, the cleavage of 2,2-dimethoxy-1,2-diphenyl-ethan-1-one mainly yields a methoxybenzyl and benzoyl radical. The benzoyl radical initiate free radical polymerization, whereas the methoxybenzyl radical decomposes to produce the more stable methyl radical and methyl benzoate.

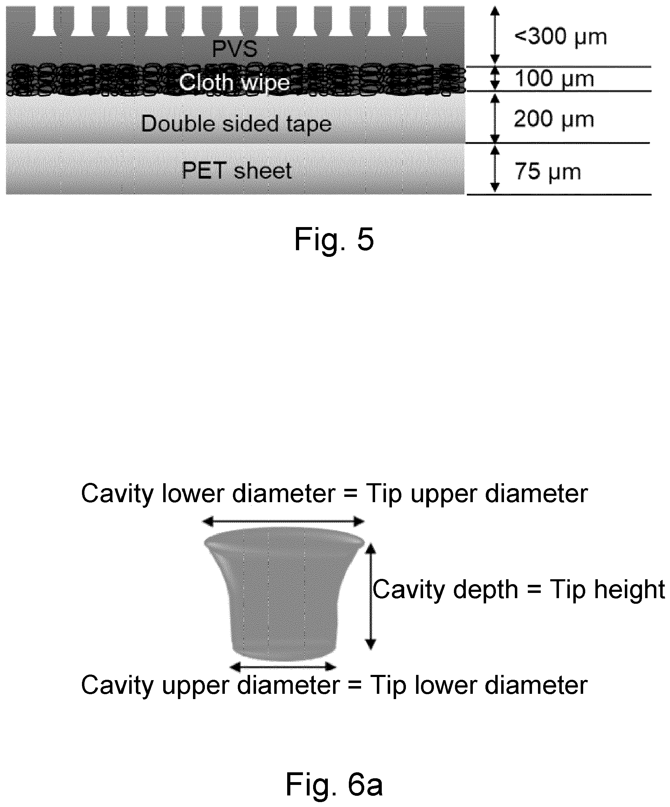

In one embodiment, the mold layer further comprises a bottom layer and at least one intermediate layer, the at least one intermediate layer being situated between the microstructured mold top layer and the bottom layer; see Fig. 5. As used herein, the mold top layer refers to the microstructured mold for casting the UV-curable material, the mold top layer being attached to the base layer via at least one intermediate layer. The term "at least one intermediate layer" used herein refers to at least one intermediate layer which acts as an adhesive suitable for attaching the base and the mold top layer together. In a preferred embodiment, the at least one intermediate layer additionally comprises at least one non-adhesive intermediate layer.

In a preferred embodiment, the mold layer comprises at least two intermediate layers. In a preferred embodiment, the mold layer comprises two intermediate layers, wherein the second intermediate layer is situated on top of the base layer, and the first intermediate layer is arranged between the mold top layer and the second intermediate layer, the second intermediate layer being an adhesive layer, and the first intermediate layer being a non-adhesive layer. In another preferred embodiment, the mold layer comprises three intermediate layers, wherein the third intermediate layer is situated on top of the base layer, the first intermediate layer is situated below the mold top layer, and the second intermediate layer is arranged between the third intermediate layer and the first intermediate layer, the third intermediate layer being an adhesive layer, the second intermediate layer being a non-adhesive layer, and the first intermediate layer being an adhesive layer or a non-adhesive layer.

The term "non-adhesive intermediate layer" used herein refers to any kind of non-adhesive layer applicable as intermediate layer between the mold top layer and an adhesive intermediate layer. Non-limited examples are a woven sheet, a cloth, a cloth wipe, a fibre sheet, a fibre cloth, a woven cloth, a linen sheet, a linen cloth, a cotton sheet, a cotton cloth, a microfibre sheet, a microfibre cloth, or a combination thereof. The term "adhesive intermediate layer" used herein refers to any kind of adhesive layer applicable as intermediate layer between the base layer and the mold top layer or a non-adhesive intermediate layer. Non-limited examples thereof are solid adhesive, such as double-sided tape, liquid adhesive, such as glue, or a combination thereof.

In a preferred embodiment, the mold layer comprises two intermediate layers, the bottom layer being a PET layer, the second intermediate layer being a double-sided tape, and the first intermediate layer being a cloth wipe; see Fig. 5.

In one embodiment, the microstructured mold top layer has a height of about 5000 $\mu$m or less. The term "about" as used herein with regard to the height of the microstructured top layer refers to a deviation of $\pm$ 0.5 $\mu$m. The term "height of the microstructured mold top layer" used herein refers to the height of the mold top layer in the mold layer comprising a base layer, a mold top layer, and at least one intermediate layer; see Fig. 5. The term "height of the microstructured top layer" does not refer to a cavity depth/cavity height.

In a preferred embodiment, the height of the microstructured mold top layer is about 4000 $\mu$m or less. In another preferred embodiment, the height of the microstructured mold top layer is about 3000 $\mu$m or less. In another preferred embodiment, the height of the microstructured mold top layer is about 2000 $\mu$m or less. In another preferred embodiment, the height of the microstructured mold top layer is about 1000 $\mu$m or less. In another preferred embodiment, the height of the microstructured mold top layer is about 600 $\mu$m or less. In another preferred embodiment, the height of the microstructured mold top layer is about 500 $\mu$m or less. In another preferred embodiment, the height of the microstructured mold top layer is about 400 $\mu$m or less. In another preferred embodiment, the height of the microstructured mold top layer is about 300 $\mu$m or less. In another preferred embodiment, the height of the microstructured mold top layer is about 200 $\mu$m or less.

In one embodiment, the height of the microstructured top layer makes up about 95% or less of the total height of the mold layer. In a preferred embodiment, the height of the microstructured top layer makes up about 93% or less of the total height of the mold layer. In another preferred embodiment, the height of the microstructured top layer makes up about 90% or less of the total height of the mold layer. In another preferred embodiment, the height of the microstructured top layer makes up about 80% or less of the total height of the mold layer. In another preferred embodiment, the height of the microstructured top layer makes up about 70% or less of the total height of the mold layer. In another preferred embodiment, the height of the microstructured top layer makes up about 60% or less of the total height of the mold layer. In another preferred embodiment, the height of the microstructured top layer makes up about 50% or less of the total height of the mold layer. In another preferred embodiment, the height of the microstructured top layer makes up about 45% or less of the total height of the mold layer. In another preferred embodiment, the height of the microstructured top layer makes up about 40% or less of the total height of the mold layer. The term "about" relating to the

percental height of the microstructured top layer in the mold layer means a deviation of $\pm 0.5\%$.

In a preferred embodiment, the height of the microstructured top layer makes up about 44% of the total height of the mold layer; see Fig. 5.

In one embodiment, the microstructured mold top layer comprises micrometer-sized cavities having a mean cavity depth, a mean cavity upper diameter, and a mean cavity lower diameter;

wherein the mean cavity upper diameter is a mean diameter of an upper end of the cavity;
wherein the mean cavity lower diameter is a mean diameter of a lower end of the cavity; and
wherein the cavities are uniformly arranged to one another with a mean center to center distance of 5000 $\mu$m or less with hexagonal array, preferably 100 $\mu$m or less.

Fig. 6a illustrates preferred dimensions of a tip in the microstructured and fully cured casting of the present invention. The cavity lower diameter refers to the lower diameter of a cavity in the microstructured mold top layer. Since molding generally produces a negative shape of the mold pattern, the cavity lower diameter corresponds to the upper diameter of a tip (i.e., tip upper diameter) in the 3D-microstructured and fully cured casting. Similarly, the cavity upper diameter referring to the upper diameter of a cavity in the microstructured mold top layer, corresponds to the lower diameter of a tip (i.e., tip lower diameter) in the 3D-patterend microstructured and fully cured casting. The cavity depth refers to the depth of a cavity in the 3D-microstructured mold top layer and corresponds to the height of a tip (i.e., tip height) in the 3D-microstructured and fully cured casting. In the present invention, using a microstructured mold top layer having a cavity lower diameter of X, a cavity upper diameter of Y, and a cavity depth of Z results in the manufacturing of a 3D-microstructured and fully cured casting, wherein a tip has the dimensions of X for the tip upper diameter, Y for the tip lower diameter, and Z for the tip height.

In a preferred embodiment, the cavity upper diameter lies in a range of from about 200 $\mu$m to about 50 $\mu$m. In another preferred embodiment, the cavity upper diameter is about 150 $\mu$m or less. In another preferred embodiment, the cavity upper diameter is about 140 $\mu$m or less. In another preferred embodiment, the cavity upper diameter is about 120 $\mu$m or less. In another preferred embodiment, the cavity upper diameter is about 100 $\mu$m or less. In another preferred embodiment, the cavity upper diameter is about 80 $\mu$m or less. In another preferred embodiment, the cavity upper diameter is about 70 $\mu$m or less. In another preferred embodiment, the cavity upper diameter is about 60 $\mu$m or less.

In a preferred embodiment, the cavity lower diameter lies in a range of from about 200 $\mu$m to about 30 $\mu$m. In another preferred embodiment, the cavity lower diameter is about 150 $\mu$m or less. In another preferred embodiment, the cavity lower diameter is about 120 $\mu$m or less. In another preferred embodiment, the cavity lower diameter is about 100 $\mu$m or less. In another preferred embodiment, the cavity lower diameter is about 80 $\mu$m or less. In another preferred embodiment, the cavity lower diameter is about 70 $\mu$m or less. In another preferred embodiment, the cavity lower diameter is about 60 $\mu$m or less. In another preferred embodiment, the cavity lower diameter is about 40 $\mu$m or less.

In a preferred embodiment, the cavity depth lies in a range of from about 150 $\mu$m to about 40 $\mu$m. In another preferred embodiment, the cavity depth is about 140 $\mu$m or less. In another preferred embodiment, the cavity depth is about 135 $\mu$m or less. In another preferred embodiment, the cavity depth is about 130 $\mu$m or less. In another preferred embodiment, the cavity depth is about 110 $\mu$m or less. In another preferred embodiment, the cavity depth is about 100 $\mu$m or less. In another preferred embodiment, the cavity depth is about 80 $\mu$m or less. In another preferred embodiment, the cavity depth is about 70 $\mu$m or less. In another preferred embodiment, the cavity depth is about 60 $\mu$m or less. In another preferred embodiment, the cavity depth is about 50 $\mu$m or less.

In a particularly preferred embodiment, the cavity lower diameter is about 70 $\mu$m, the cavity upper diameter is about 50 $\mu$m, and the cavity depth is about 60 $\mu$m.

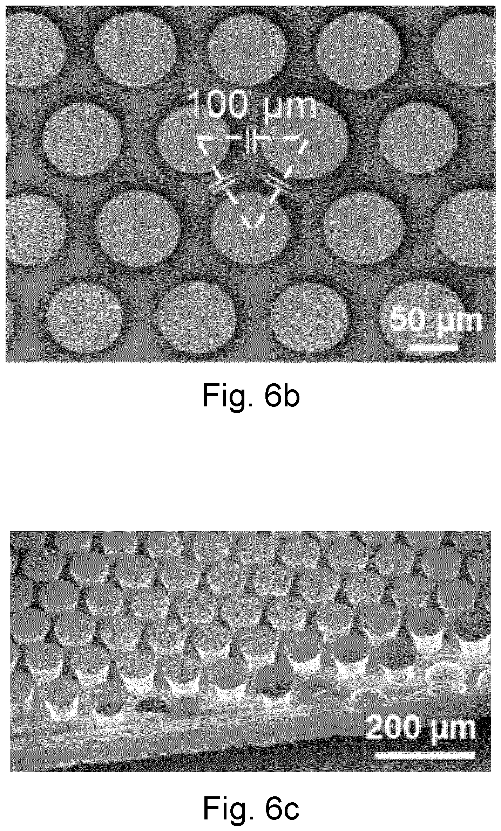

Fig. 6b and Fig. 6c illustrate a microstructured and fully cured casting made of PUA obtained according to the present invention from a top view and angled view, respectively. As can be seen in the figures, the tips of the 3D-patterned microstructure are formed in a three-dimensional and uniform pattern, wherein each tip has a similar distance to adjacent tips with respect to the longitudinal axis of a tip (center-to-center distance; see center-to-center distance of 100 $\mu$m determined with respect to the longitudinal axis of three adjacent tips in Fig. 6b).

In a preferred embodiment, the cavities are uniformly arranged to one another with a mean center to center distance of about 5000 $\mu$m or less with hexagonal array. In another preferred embodiment, the cavities are uniformly arranged to one another with a mean center to center distance of about 4000 $\mu$m or less with hexagonal array. In another preferred embodiment, the cavities are uniformly arranged to one another with a mean center to center distance of about 3000 $\mu$m or less with hexagonal array. In another preferred embodiment, the cavities are uniformly arranged to one another with a mean center to center distance of about 2000 $\mu$m or less with hexagonal array. In another preferred embodiment, the cavities are uniformly arranged to one another with a mean center to center distance of about 1000 $\mu$m or less with hexagonal array. In another preferred embodiment, the cavities are uniformly arranged to one another with a mean center to center distance of about 500 $\mu$m or less with hexagonal array. In another preferred embodiment, the cavities are uniformly arranged to one another with a mean center to center distance of about 300 $\mu$m or less with

hexagonal array. In another preferred embodiment, the cavities are uniformly arranged to one another with a mean center to center distance of about 200 $\mu$m or less with hexagonal array. In another preferred embodiment, the cavities are uniformly arranged to one another with a mean center to center distance of about 100 $\mu$m or less with hexagonal array. In another preferred embodiment, the cavities are uniformly arranged to one another with a mean center to center distance of about 80 $\mu$m or less with hexagonal array.

In a particularly preferred embodiment, the cavities tips are uniformly arranged to one another with a mean center to center distance of about 100 $\mu$m, as shown for the corresponding tip arrangement of a 3D-patterned microstructure in Fig. 6b.

The term "about" relating to the cavity dimensions in the microstructured mold top layer means a deviation of $\pm0.5\%$.

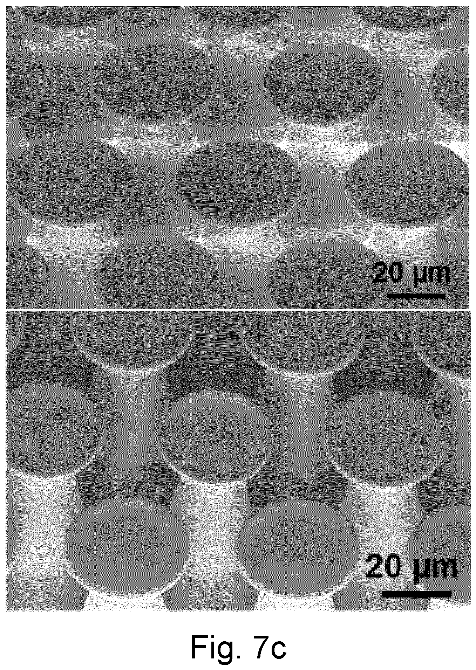

In one embodiment, the cavities of the microstructured mold top layer are mushroom-shaped, cylindrical, truncated cone-shaped, wedge-shaped, or flap-shaped. In a preferred embodiment, the cavities of the microstructured mold top layer are mushroom-shaped or truncated cone-shaped. The tips of a 3D-patterned microstructure resulting from truncated cone-shaped cavities of a mold top layer may be seen in Fig. 6a to 6c and Fig. 7a. The tips of a 3D-patterned microstructure resulting from mushroom-shaped cavities of a mold top layer may be seen in Fig. 7c. A mold having mushroom-shaped cavities is schematically illustrated in Fig. 7b.

In one embodiment, the microstructured mold top layer is obtained by an inking process (dip-transfer process) or a two-photon polymerization process. In a preferred embodiment, the microstructured mold top layer is obtained by an inking process (dip-transfer process).

A general procedure of the inking process (shown in Fig. 8) and the two-photon polymerization process, respectively, comprises the steps described in Example 1.

In one embodiment, the microstructured mold top layer is not metal-based. The term "metal-based" as used herein does not exclude naturally occurring traces of metals, and/or metals added as an auxiliary agent and/or as an additive during the manufacturing of the microstructured mold top layer. As used herein, the term "metal-based" means that a mold comprises at least one metal as main component. "Metal-based" as used herein also refers to a mold which comprises a polymer-metal composite. A metal-based mold may be typically rigid in solid form and usually exhibits poor flexibility and/or stretchability. Metal-based molds are generally associated with a manufacturing difficulty when it comes to the preparation of a micropatterned metal-based mold top layer, for example due to the rigid nature of metals. In particular, the manufacturing of a metal-based mold top layer having a complex 3D microstructure is comparatively more difficult and more expensive.

In contrast thereto, the microstructured mold top layer of the present invention is flexible. Without excluding traces of metals or metals incorporated as additives and/or auxiliary agents in the mold, the microstructured mold top layer according to the present invention is also stretchable. In a preferred embodiment, the microstructured mold top layer consists of a polymer, preferably wherein the polymer is a resin.

In one embodiment, the microstructured mold top layer has a UV transmission of about 80 % or less, preferably of 70 % or less, more preferably of about 60 % or less, more preferably of about 50 % or less, more preferably of about 40 % or less, more preferably of about 30 % or less, more preferably of about 20 % or less, more preferably of about 15 % or less, more preferably of about 10 % or less, more preferably of about 5 % or less, and even more preferably of 2 % or less. The term "about" relating to the UV transmission of the microstructured mold top layer means a deviation of $\pm0.5\%$.

A microstructured mold top layer having a UV transmission as described above enhances the technical effects of the present invention. In other words, the microstructured mold top layer used herein is exhibits moderate to poor transparency towards UV light, preferably exilities no transparency towards UV light. For example, a microstructured mold top layer made of PDMS or PFPE has a moderate transparency towards UV light. Even though PDMS or PFPE may be used to reach the advantages of the present invention, said advantages are even enhanced when a microstructured mold top layer is made of PVS which has an even more reduced UV transmission with regard to PDMS or PFPE.

Without being bound by theory, a microstructured mold top layer having a higher UV transmission is associated with an increased and/or accelerated partial curing of the raw casting comprising the UV-curable material during step d). This may be associated with reaching a curing level for the UV-curable material lying beyond being partially cured, and hence results in reduced advantages of the present invention, such as reduced flexible mold lifetime and/or reduced flexible repeatability.

In one embodiment, the microstructured mold top layer is opaque. In a preferred embodiment, opaque PVS is used. Alternatively, the microstructured mold top layer is coloured. In a preferred embodiment, coloured PVS is used.

In one embodiment, the microstructured mold top layer has an oxygen transmission rate of 100 cc/m$^2$/24hrs or more, preferably of 5,000 cc/m$^2$/24hrs or more, preferably of 10,000 cc/m$^2$/24hrs or more, more preferably of 25,000 cc/m$^2$/24hrs or more, more preferably of 50,000 cc/m$^2$/24hrs or more, more preferably of 75,000 cc/m$^2$/24hrs or more, and even more preferably of 100,000 cc/m$^2$/24hrs or more. A microstructured mold top layer having an oxygen transmission rate in these ranges is associated with improved advantages of the present invention, in particular enhanced flexible mold lifetime, and/or enhanced flexible mold repeatability.

Without being bound by theory, the advantages may be more easily reached using a microstructured mold top layer having an oxygen transmission rate in the above-mentioned range because of an increased oxygen inhibition effect. Unlike the state of the art, the present invention uses a microstructured mold top layer which is prone to the oxygen inhibition effect. In other words, the microstructured mold top layer of the present invention is particularly permeable to oxygen. It is thus one embodiment, wherein the microstructured mold top layer does not comprise oxygen impermeable materials, such as PET or glass.

In one embodiment, the microstructured mold top layer comprises polyvinylsiloxane (PVS), polydimethylsiloxane (PDMS), polyurethane acrylate (PUA), butyl rubber, liquid crystal elastomer, fluorinated silicone, silicone rubber, and/or perfluoropolyether (PFPE), preferably polyvinylsiloxane (PVS). In a preferred embodiment, the microstructured mold top layer is made of polyvinylsiloxane (PVS), polydimethylsiloxane (PDMS), polyurethane acrylate (PUA), butyl rubber, liquid crystal elastomer, fluorinated silicone, silicone rubber, and/or perfluoropolyether (PFPE), preferably polyvinylsiloxane (PVS). In a preferred embodiment, the microstructured mold top layer is made of PVS, PDMS or PFPE. In a particularly preferred embodiment, the microstructured mold top layer is made of PVS or PDMS. In a more preferred embodiment, the microstructured mold top layer is made of PVS.

In one embodiment, in step c) of the method according to the first aspect of the invention the at least one part of the cavities of the microstructured mold top layer is filled with the UV-curable material by pressing the UV-curable material onto the microstructured mold top layer with a pressure of 0.01 MPa or more, thereby filling at least one part of the cavities of the microstructured mold top layer. In a preferred embodiment, a pressure of 0.1 MPa or more is applied, more preferably a pressure of 0.5 MPa or more, more preferably a pressure of 1 MPa or more, even more preferably a pressure of 1.5 MPa or more, even more preferably a pressure of 2 MPa or more, even more preferably a pressure of 2.5 MPa or more, even more preferably a pressure of 3 MPa or more, even more preferably a pressure of 4 MPa or more, and even more preferably a pressure of 5 MPa or more.

The term "the at least one part of the cavities" refers to at least 50 %, based on the total volume of the cavities; preferably at least 60%, based on the total volume of the cavities; more preferably at least 70 %, based on the total volume of the cavities; more preferably at least 80 %, based on the total volume of the cavities; more preferably at least 90 %, based on the total volume of the cavities; and more preferably at least 95 %, based on the total volume of the cavities.

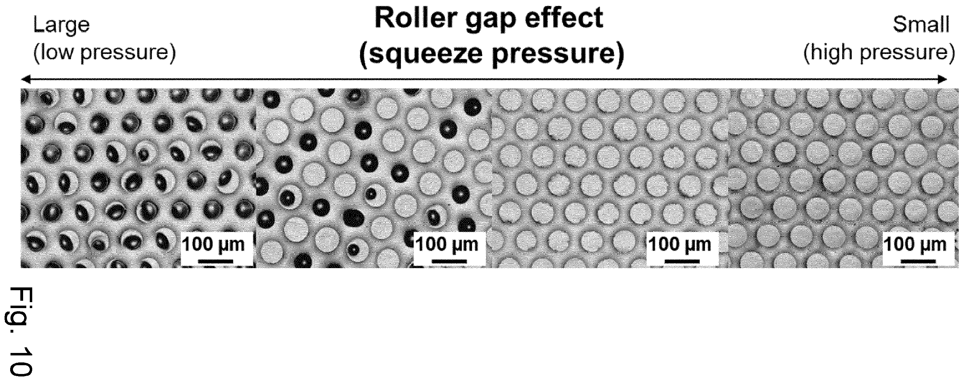

Pressing the UV-curable material onto the microstructured mold top layer is preferably performed by adjustment of the gap between the pressing roller and the molding roller. The smaller the gap, the larger the pressure, and vice versa. In Fig. 10, the effect of the pressure on the microstructured top layer made of PVS to be filled with a UV-curable material being PUA is shown. When the gap between the pressing (squeezing) roller and the molding roller is large, the squeezing (pressing) pressure is low and the resin cannot completely fill the voids of the patterned mold top layer. As the gap decreases, the squeezing pressure increased and the voids can be completely filled with the resin. A further decrease of the gap is associated with a deformation of the pattern and the backing layer of the mold top layer due to the higher pressure.

In one embodiment, a PET layer is situated on top of the UV-curable material and the pressure of 0.01 MPa or more is applied to the PET layer situated on top of the UV-curable material, thereby filling at least one part of the cavities of the microstructured mold top layer with the UV-curable material.

It is essential for the present invention that during the partial curing step is performed at a UV intensity of about 10,000 mW/cm$^2$ or less. In another preferred embodiment, the UV intensity during the first curing step is about 1 mW/cm$^2$ or more. In a preferred embodiment, the UV intensity during the first curing step is about 50 mW/cm$^2$ or less, more preferably about 30 mW/cm$^2$ or less, more preferably about 10 mW/cm$^2$ or less, more preferably about 8 mW/cm$^2$ or less, more preferably about 7 mW/cm$^2$ or less, more preferably about 5 mW/cm$^2$ or less, more preferably about 3 mW/cm$^2$ or less, more preferably about 2 mW/cm$^2$ or less, and even more preferably about 1.5 mW/cm$^2$ or less. The term "about" relating to the UV intensity during the first curing step means a deviation of $\pm$0.05 mW/cm$^2$.

The required UV intensity in the range of 10,000 mW/cm$^2$ or less during the partial curing in step d) of the present invention may depend on different criteria, such as the UV wavelength during the first curing step, the choice of the UV-curable material, the oxygen inhibition effect of the mold layer, and/or the UV transmittance of the mold layer. In preferred embodiments, the UV intensity during the first curing step is about 6.6 mW/cm$^2$, about 2 mW/cm$^2$, or about 1.4 mW/cm$^2$.

In one embodiment, the first curing step is carried out at a UV wavelength of from about 320 nm to about 390 nm, preferably of from about 340 nm to about 380 nm, preferably of from about 350 nm to about 375 nm, and more preferably of from about 360 nm to about 370 nm. The term "about" relating to the UV intensity during the first curing step means a deviation of $\pm$0.05 nm.

The required UV wavelength during the partial curing in step d) of the present invention depends on different criteria, such as the UV intensity in the range of 10,000 mW/cm$^2$ or less during the first curing step, the choice of the UV-curable material, the oxygen inhibition effect of the mold layer, and/or the UV transmittance of the mold layer. In particular, the required UV wavelength depends on the choice of the UV-curable material, the optionally used photoinitiator, and the UV transmittance of the base layer comprising the UV-curable material (such as PET web) being transferred from the pressing roller to the demolding roller via the molding roller. In a preferred embodiment, the first curing step is carried out at a UV wavelength of about 365 nm.

For example, using PUA as UV-curable material, and a microstructured mold top layer made of PDMS or PVS requires a UV intensity of about 2 mW/cm$^2$ at a UV wavelength of 365 nm with partial curing time of 3 minutes, or requires a UV intensity of about 6.6 mW/cm$^2$ at a UV wavelength of 365 nm with a partial curing time of 50 seconds.

In one embodiment, at least about 50% of the microstructured surface of the partially cured casting is uncured, preferably at least about 70%, preferably at least about 80%, preferably at least about 90%, and more preferably at least about 95%. As shown in Experiment 2 and Fig. 9, the flexible mold repeatability is not only influenced by the UV intensity applied during the first curing step but also by the partial curing of the UV-curable resin itself, i.e., whether the partial curing thereof is incomplete, complete, or lies beyond being complete. As explained above, it is advantageous for the present invention that the partial curing is complete.

In one embodiment, the UV intensity during the second curing step is about 1 mW/cm$^2$ or more. In a preferred embodiment, the UV intensity during the second curing step is about 1.2 mW/cm$^2$ or more, more preferably about 1.4 mW/cm$^2$ or more, more preferably about 1.6 mW/cm$^2$ or more, more preferably about 1.8 mW/cm$^2$ or more, more preferably about 2 mW/cm$^2$ or more, more preferably about 5 mW/cm$^2$ or more, more preferably about 10 mW/cm$^2$ or more, more preferably about 20 mW/cm$^2$ or more, even more preferably about 40 mW/cm$^2$ or more, and even more preferably about 100 mW/cm$^2$ or more. In a preferred embodiment, the UV intensity during the second curing step is about 1.2 mW/cm$^2$. The term "about" relating to the UV intensity during the second curing step means a deviation of $\pm 0.05$ mW/cm$^2$.

In one embodiment, the second curing step is carried out at a UV wavelength of from about 320 nm to about 220 nm, preferably of from about 300 nm to about 240 nm, and more preferably of from 260 nm to about 250 nm. In a preferred embodiment, the second curing step is carried out at a UV wavelength of about 254 nm.

In one embodiment, a UV intensity applied during the second curing step is smaller than a UV intensity applied during the first curing step, and/or a UV wavelength applied during the second curing step is smaller than a UV wavelength applied during the first curing step.

In a preferred embodiment, a UV wavelength applied during the second curing step is smaller than a UV wavelength applied during the first curing step.

The second aspect of the invention relates to a 3D-patterned microstructure obtained by the method according to the first aspect of the invention.

In a preferred embodiment, the 3D-patterned microstructure obtained by the method according to the first aspect of the invention is an adhesive 3D-patterned microstructure, a frictional 3D-patterned microstructure, a gripping 3D-patterned microstructure, a closure device comprising the 3D-patterned microstructure, an optically active 3D-patterned microstructure, an air/fluid drag-control device comprising the 3D-patterned microstructure, an antifouling 3D-patterned microstructure, an anti-fogging 3D-patterned microstructure, a super-wetting 3D-patterned microstructure, a thermally insulating 3D-patterned microstructure, a thermally conductive 3D-patterned microstructure, a skin-adhesive 3D-patterned microstructure, an electrically insulating 3D-patterned microstructure, an electrically conductive 3D-patterned microstructure, an actuator device comprising the 3D-patterned microstructure, a sensor device comprising the 3D-patterned microstructure, a flexible circuit device comprising the 3D-patterned microstructure, a battery device comprising the 3D-patterned microstructure, and/or a non-wetting 3D-patterned microstructure.

In a particularly preferred embodiment, the 3D-patterned microstructure obtained by the method according to the first aspect of the invention is an adhesive 3D-patterned microstructure, a frictional 3D-patterned microstructure, and/or a non-wetting 3D-patterned microstructure.

The suitability of the 3D-patterned microstructure for one type of application, does not exclude its suitability for another one. For example, a 3D-patterned microstructure may have high adhesive properties and high frictional properties, and vice versa. Also, a 3D-patterned microstructure may have high adhesive properties and low frictional properties, and vice versa. The invention presented herein discloses a method for the manufacturing of 3D-patterned microstructures having complex and/or diverse designs so that depending on its application the required design of the microstructures may be manufactured.

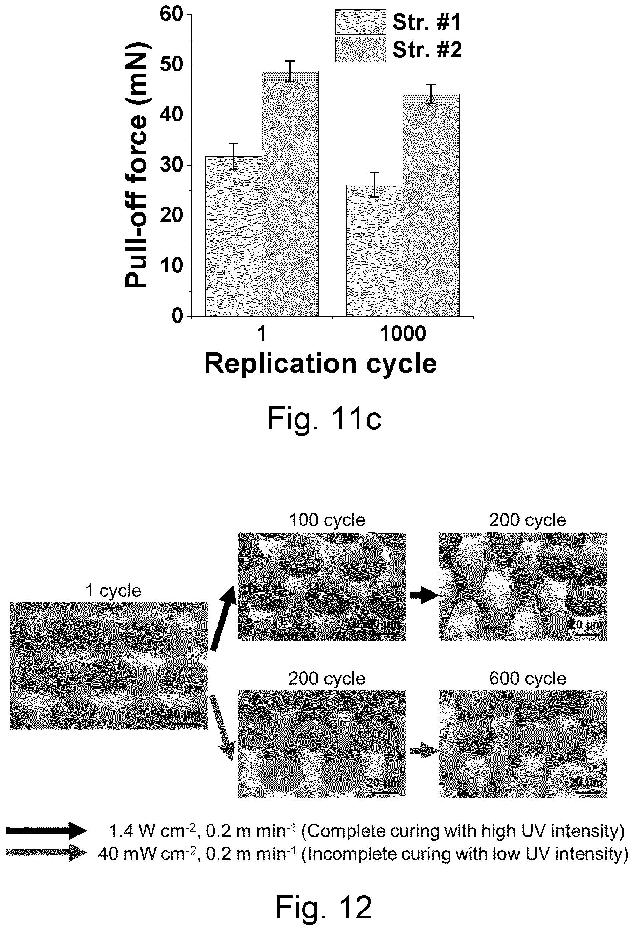

In one embodiment, the 3D-patterned microstructure has a pull-off force of at least 20 mN after a replication cycle of 1,000, preferably of at least 30 mN after a replication cycle of 1,000, preferably of at least 35 mN after a replication cycle of 1,000, even more preferably of at least 40 mN after a replication cycle of 1,000, even more preferably of at least 45 mN after a replication cycle of 1,000, and even more preferably of at least 50 mN after a replication cycle of 1,000; see Fig. 11c and Example 7.

In one embodiment, the 3D-patterned microstructures of the present invention show enhanced adhesion performance. This was observed on rough metal surface (such as on silicon wafer backside), on rough plastic surface, and/or on smooth surface (such as glass surface). In a preferred embodiment, the adhesive 3D-patterned microstructure has the ability to lift up objects of 0.76 kg$\pm 0.2$ kg (30 kPa$\pm 0.2$ kPa), 0.15 kg (6 kPa$\pm 0.2$ kPa), or about 3.36 kg$\pm 0.2$

kg (130 kPa±0.2 kPa).

The third aspect of the invention relates to a use of a 3D-patterned microstructure manufactured according to the first aspect of the present invention as at least one of a synthetic dry adhesive comprising a tape, a biomimetic adhesive comprising a gecko-inspired adhesive, a high gripping tape or surface, a non-slip tape or surface, a skin/tissue-adhesive tape or surface, a skin/tissue-gripping tape or surface, a closure tape or surface, a non-wetting tape or surface, a liquid-repellent tape or surface, a liquid-repellent adhesive tape or surface, a self-cleaning tape or surface, an anti-reflection coating, a drag reduction coating, an anti-fouling coating, an anti-fogging coating, a non-icing coating, a flexible electronic device, an optical device, a ciliated actuator device, an actuator device, a sensor device, a structured flexible battery, a solar cell layer, and/or a robotic device.

The fourth aspect of the invention relates to an apparatus for manufacturing a 3D-patterned microstructure, the apparatus being configured to carry out a method according to the first aspect of the invention, the apparatus being a printing unit of an R2R UV-curing manufacturing system, comprising:

> a pressing roller, a molding roller comprising a mold layer on an outer surface of the molding roller, and a demolding roller arranged in a series one after another;
> a first UV curing system being attached to the molding roller, or being arranged at the molding roller, and being configured to carry out a first curing step at a UV intensity of 10,000 mW/cm$^2$ or less;
> a second UV curing system being attached to the demolding roller, or being arranged after the demolding roller, the second UV curing system being configured to carry out a second curing step;
> the pressing roller and the molding roller being arranged to one another in a distance configured to press a UV-curable material onto the mold layer with a pressure of 1 MPa or more; and
> the molding roller and the demolding roller being arranged to one another in an angle configured to provide a demolding angle of at least about 80 degrees, preferably 90 degrees.

In one embodiment, the mold layer may be attached to the outer surface of the molding roller by using an adhesive layer of any kind applicable for attaching the mold layer to the outer surface of the molding roller. Non-limited examples thereof are solid adhesive, such as double-sided tape, liquid adhesive, such as glue, or a combination thereof.

In one embodiment, the second UV curing system required for the second curing step is attached to the demolding roller. This arrangement would be similar as the arrangement of the first UV system required for the first curing step attached to the molding roller. In a preferred embodiment, the second UV curing system is arranged after the demolding roller, i.e., the second UV curing system and the demolding roller are not directly connected/attached.

In one embodiment, the pressing roller (i.e., squeezing roller) and the molding roller are arranged to each other in a distance configured to press a UV-curable material onto the mold layer with a pressure of 1 MPa or more. The arrangement required for a high pressure as well as the effect on the filling of the mold top layer cavities was described above; see also Fig. 10.

As described above, it is typical for a conventional UV-R2R apparatus to have a demolding angle of less than about 80 degrees; see Fig. 2. The term "about" with respect to a demolding angle described herein is referred to a deviation of ± 2 degrees. The "demolding angle" is determined from a side view on a UV-R2R printing unit, such as seen in Fig. 2 and 3, and is defined as the angle between the base layer (e.g., fed PET web) strained between the molding roller and the demolding roller and being forwarded to the demolding roller, and a predetermined horizontal line on the molding roller (see horizonal line shown as continuous horizontal lines in Fig. 2 and 3). The horizontal line on the molding roller is a hypothetical horizontal line positioned on top of the molding roller, said line starting horizontally from a longitudinal centre of the molding roller outer surface and running towards the strained base layer (e.g., fed PET web). Alternatively, the "demodling angle" may be defined as an angle between the mold top layer and a part of the strained base layer at which demolding takes place.

In the present invention, the molding roller and the demolding roller are arranged to one another in an angle to provide a higher demolding angle, namely of at least 80 degrees; see Fig. 3. In a preferred embodiment, the demolding angle is about 85 degrees. In a more preferred embodiment, the demolding angle is about 90 degrees.

The higher demolding angle is associated with a lower stress generation while demolding the printed and partially cured casting comprising the UV-curable material. In the present invention, the term "partially cured casting" refers to a partially cured casting comprising a partially cured UV-curable material having a microstructured surface. Not only does the higher demolding angle enable a gentler demolding of the printed and partially cured UV-curable material so that the microstructures formed thereon are less damaged, thereby providing a microstructure having a more uniform and more accurate microstructure which for example is associated with an improved adhesion performance. Also, the higher demolding angle enables a gentler demolding of the flexible mold top layer, thereby providing a flexible mold with an enhanced lifetime and enhanced replication cycle.

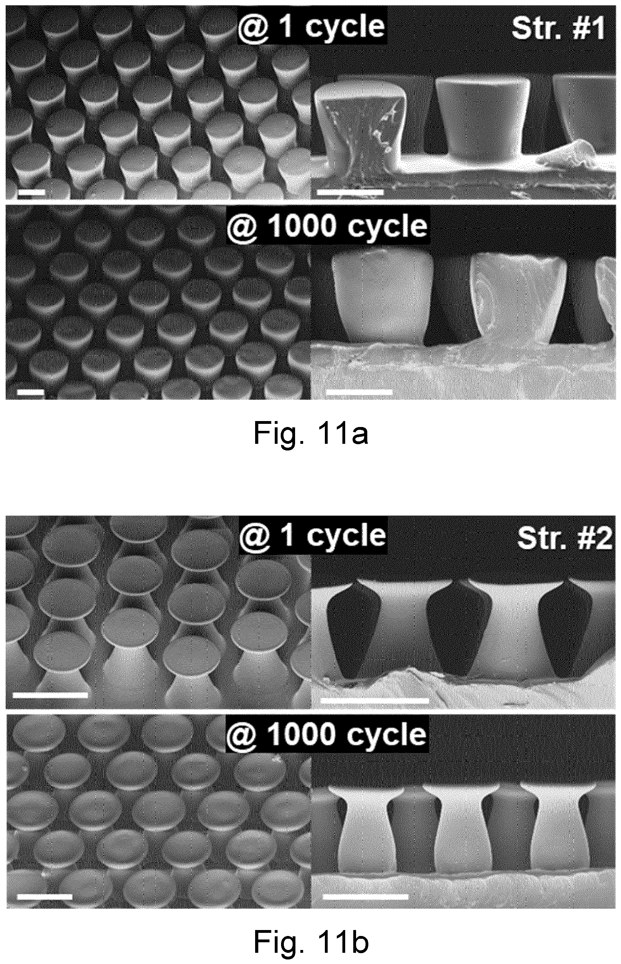

In one embodiment, the mold layer comprising the flexible mold top layer has a flexible mold repeatability of 200 cycles or more, preferably of 400 cycles or more, preferably of 600 cycles or more, preferably of 800 cycles or more, and more preferably of 1,000 cycles or more, and even more preferably of 1,200 cycles or more; see Fig. 11a-b, and Examples 5 and 6.

In one embodiment, the time between the beginning and the end of one replication cycle (also referred to as "replication cycle time") is at least 120 seconds, preferably at least 110 seconds, more preferably at least 100 seconds, even more preferably at least 90 seconds, even more preferably at least 60 seconds. The longer the replication cycle time, the slower the manufacturing rate of the 3D-patterned microstructure printed.

### Experimental Section

#### *Materials and Methods:*

Three different types of polyvinyl siloxane (PVS), three different types of polydimethylsiloxane (PDMS), and one type of perfluoropolyether (PFPE) were used as mold material in the experiments:

| PVS | PDMS | PFPE |
|---|---|---|
| Affinis Perfect Impression Light Body (Coltene) | Sylgard 184 (Dow Corning) | Fluorolink MD 700, Solvay[1] |
| Flexitime Medium Flow (Kulzer GmbH) | Elastosil M4601 (Wacker) | |
| Correct Flow (Kulzer GmbH). | Mold Star 30 (Smooth-On) | |
| [1] mixed with 3 wt% of photoinitiator 2-hydroxy-2-methylpropiophenon (Sigma-Aldrich) | | |

Four different types of polyurethane acrylate (PUA) were used to as UV-curable material:

| PUA |
|---|
| EBECRYL 4491 (Allnex)[1] |
| Laromer UA9072 (BASF)[1] |
| Miramer UA5220NT (Miwon)[1] |
| Elastic 50A (Formlabs) |
| [1] mixed with 3 wt% of photoinitiator 2-hydroxy-2-methylpropiophenon (Sigma-Aldrich) |

In the following Experiments, no specification on the used PVS, PDMS or PUA resin is made since the advantageous effects of the present invention were obtained for each used type. Hence, using the term "PVS", "PDMS" or "PUA" in the following means that the experiments may be performed with either type listed above, thereby in each case obtaining the advantageous effects of the present invention.

Procedure of making a microstructured PVS mold top layer:

#### *a) Inking process*

As shown in Fig. 8, the inking process begins with the Si wafer being negatively patterned with micropillars having a diameter and height of about 50 $\mu$m, which was used to replicate micropillars made of PDMS. In order to add wide tips on the pillars, a 20-$\mu$m-thick layer of PVS resin (Light Body Perfect Impression) was prepared by a film applicator (Multicator 411, ERICHSEN) before the PVS resin was completely polymerized, and the PDMS micropillars were gently dipped into the PVS layer. The dipped PDMS micropillars were pressed to a Si wafer by its own weight, and waited for 10 min until the PVS resin on top of the micropillars was completely cured. After detaching the PDMS sample from the Si wafer, it was used as a positive mold for making negative molds. The PDMS mold was plasmatreated by a plasma cleaner (Tergeo Plasma Cleaner, PIE Scientific) for 3 min for surface activation in an oxygen environment and then silanized in a vacuum desiccator for 1 hour with 40 $\mu$l of Trichlor-(1H,1H,2H,2H-perfluoroctyl)-silan (purchased from Sigma Aldrich) in a glass vial. Depending on the required mold material, a PVS, PDMS or PFPE resin as listed above was poured onto the silanized master mold, and the final negative molds were prepared from such master.

*b) Two-photon polymerization*

As for the mold top layer formed by the two-photon polymerization, the microstructure was directly 3D-printed by a commercial two-photon polymerization system (Photonic Professional GT, Nanoscribe GmbH) with a rigid commercial photoresin (IP-S, Nanoscribe GmbH). After the printed microstructured sample was silanized through the aforementioned steps, it was used as a positive master mold.

UV absorption spectrum:

The UV absorption spectra of the UV-curable materials were measured by Fouriertransform infrared spectroscopy (TENSOR II, Bruker).

Elasticity measurement:

The Young's modulus and elongation at break of UV-curable materials were measured by using a universal testing system (5942, Instron).

Surface roughness measurement:

Optical images and surface roughness were obtained from a 3D laser scanning confocal microscope (VK-X260K, KEYENCE) with sub-nm resolution in vertical direction and about 0.13 $\mu$m resolution in lateral direction. An SEM with an EDX (Leo Gemini 1530, Carl Zeiss Microscopy GmbH) was used to observe the microstructures and to measure the atomic compositions of PVS, PUA, and damaged molds.

Pull-off force measurement:

A custom-built tribotester was used to measure the pull-off force of the 3D-patterned PUA microstructure printed. The tribotester consisted of a linear piezo stage (LPS-65, Physik Instrumente GmbH & Co. KG) with a load cell (GSO-25, Transducer Techniques) to apply a designated preload and to measure the pull-off force of the 3D-patterned microstructure samples. First, a glass hemispherical tip with a diameter of 10 mm (ACL108U-A, Thorlabs) was fixed with the load cell as the counter surface. A 3D-microstructured PUA sample was tightly fixed on a glass slide, which was located below the tip. The hemispherical tip with the load cell was moved to the test spot on the 3D-patterned microstructure by using an x-y manual stage (NFP-2462CC, Positioniertechnik Dr. Meierling) in the tribotester. After the tip was positioned, the tip approached perpendicular to the contact plane at an approaching speed of 20 $\mu$m s$^{-1}$ until a preload of 10 mN was achieved. The contact was maintained for 5 sec, and the tip was pulled off at a pull-off speed of 10 $\mu$m s$^{-1}$ until the tip was completely detached from the 3D-patterend microstructure sample while measuring the normal force. All the pull-off tests were carried out under the aforementioned conditions, and were repeated at least 4 times for all the samples tested in this study. All the pull-off force values and the average surface roughness values were presented as means $\pm$ standard deviation from at least four measurements. All the measurements were conducted in room conditions (temperature: 21~24 °C, relative humidity: 40~45%).

Adhesion performance measurement

The printed 3D-patterned PUA microstructure was cut into a small patch with an apparent contact area of 2.5 cm$^2$. The small adhesive patch was attached to a 5-mm-thick acrylic plaque with a double-sided tape, and a small screw was glued to the backside of the acrylic plaque as a grip by using a super glue. The adhesive strength was calculated based on the apparent contact area and the weight of the object. For example, the adhesive strength of an object having a weight of 3.36 kg·f (corresponds to about 33 N) on an apparent contact area of 2.5 cm$^2$ was calculated as 33 N / 2.5 cm$^2$ = about 130 kPa.

UV-R2R system:

The UV-R2R system was purchased from Coatema Coating Machinery GmbH (see Fig. 1a). The used UV R2R system has four different sections: 1. resin and PET web feeding, 2. pre-heating, 3. molding, 4. rewinding. In the first section, the PET web (Minuta Tech, thickness: 100 $\mu$m, width: 30 cm) was fed by an unwinder at a designated feeding rate and tension. In the pre-heating section, the resin fed onto the PET web can be heated, but such heating was not implemented herein. In the molding section, the processes comprising resin filling, UV curing, and demolding were carried out.

*Comparative Example 1*

*Conventional UV-R2R system and manufacturing a 3D-patterned microstructure using the conventional UV-R2R system:*

A mold top layer made of PVS or PFPE was attached to a PET sheet by using a cloth wipe and a double-sided tape with uncured resin as a glue (see Fig. 5). The mold layer comprising the mold top layer, the PET sheet, the cloth wipe, the double-sided tape, and the glue, was attached to the molding roller by using a double-sided tape. The UV-curable material (such as UV-curable resin) poured on the fed PET web (i.e., base layer) met the mold top layer between the squeezing roller and the molding roller (see Fig. 1b). The UV-curable material and mold layer were exposed to the UV light with the peak wavelength of 365 nm in a UV chamber equipped with a UV LED unit (LeoLED Cassette at 365 nm, GEW). The microstructured and fully cured UV-curable material was demolded in a low demolding angle, and collected in the rewinding section by a rewinder while keeping the rewind tension and rate.

*PVS mold top layer*

The unwinding tension and rewinding tension were kept at 40 N, and the PET feeding rate was 1 m/min resulting in a complete curing time of about 15 seconds for PUA. The UV light intensity was about 1.4 W/cm$^2$ intensity at 365 nm.

*PFPE mold top layer*

The unwinding tension and rewinding tension were kept at 40 N, and the PET feeding rate was 0.2 m/min resulting in a complete curing time of about 15 seconds for PUA. The UV light intensity was about 1.4 W/cm$^2$ intensity at 365 nm.

*Comparative Example 2*

*Flexible PFPE mold repeatability:*

The setup in Comparative Example 1 with the PFPE mold top layer was used. As shown in Fig. 12 (both top images on the right), the 3D-patterend microstructures could be printed up to 200 cycles. In contrast thereto, using the same PFPE mold top layer but applying the inventive UV R2R setup of Example 1 resulted in an enhanced mold repeatability, see Example 6.

*Comparative Example 3*

*Flexible PVS mold repeatability:*

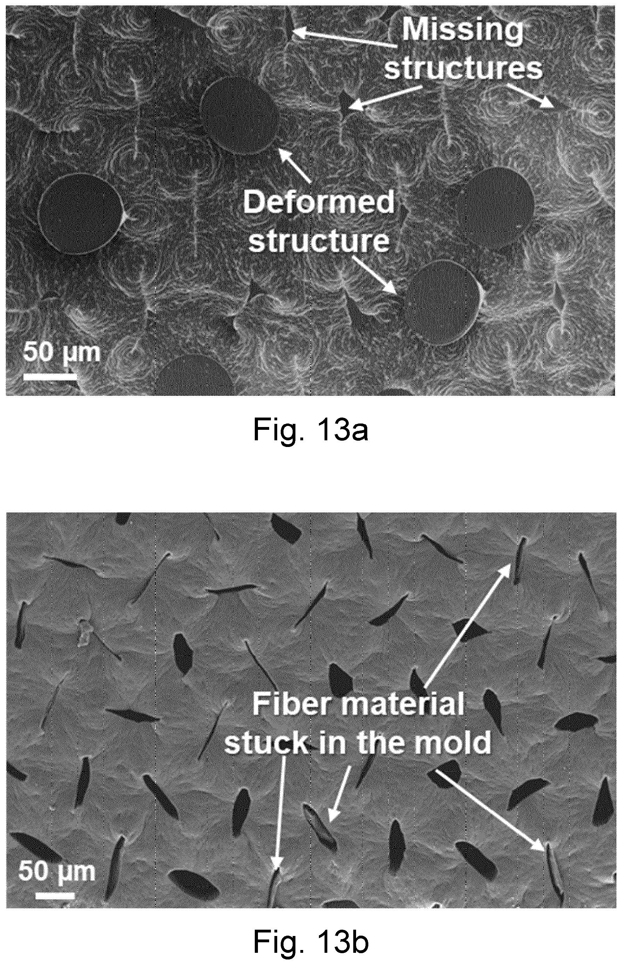

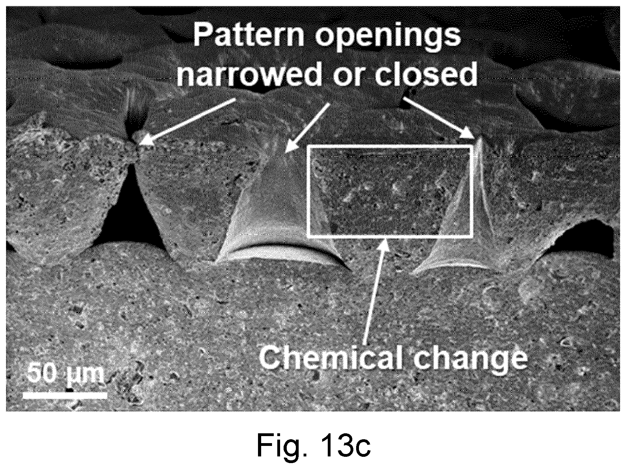

The setup in Comparative Example 1 with the PVS mold top layer was used. In Fig. 13a-c, SEM images of a 3D-patterned PUA microstructure printed according to the conventional UV R2R setup using a PVS mold top layer is shown. The damage and deformation of the mold after 10~20 replication cycles are visible; see Fig. 13b-c. The surface of the mold is deformed and its surface roughness is increased (see Fig. 13b), which resulted in the narrower entrance of the patterns (see Fig. 13c) and the deformed and missing printed microstructures (see Fig. 13a). In addition, clear chemical change is also observed in the SEM image of the cross-section of the damaged mold (see Fig. 13c), which implies that the damage grows or initiates from the top surface.

In the conventional UV-R2R system, the mold deformation with clear chemical change on the surface of the mold is observed in every mold within 20 cycles regardless of the UV curing conditions, material selection, and other manufacturing conditions, such as PET feeding rate, unwinding tension, and rewinding tension.

*Example 1*

*Inventive UV-R2R system and manufacturing a 3D-patterend microstructure on the inventive UV-R2R system:*

A mold top layer made of PVS, PDMS or PFPE was attached to a PET sheet by using a cloth wipe and a double-sided tape with uncured resin as a glue (see Fig. 5). The mold layer comprising the mold top layer, the PET sheet, the cloth wipe, the double-sided tape, and the glue, was attached to the molding roller by using a double-sided tape. The UV-curable material (such as UV-curable resin) poured on the fed PET web met the mold top layer between the squeezing roller and the molding roller (see Fig. 1b). The UV-curable material and mold layer were exposed to the UV light with the peak wavelength of 365 nm in a UV chamber equipped with a UV LED unit (first curing step; LeoLED Cassette at 365 nm, GEW). After the partially cured casting comprising the partially cured and microstructured UV-curable material was demolded in a high demolding angle, the partially cured and microstructured UV-curable material on the fed PET web was post-cured under a second UV lamp at 254 nm (second curing step; UV-15 SL, Herolab GmbH) and collected in the rewinding section by a rewinder while keeping the rewind tension and rate.

*PVS mold top layer*

The rewinding tension was about 30 N, and the PET feeding rate was 0.3 m/min. Unless defined otherwise, the applied UV light intensity was 6.6 mW/cm$^2$. This setup, comprising the conditions of the PET feeding rate being 0.3 m/min and the UV light intensity being 6.6 mW/cm$^2$ results in a complete partial curing time of 50 seconds for PUA. This UV intensity was obtained by adding 15 PET sheets in a stack on the UV LED unit with the UV transmittance of ~70% at 365 nm of the UV chamber in the first curing step.

*PFPE mold top layer*

The rewinding tension was about 30 N, and the PET feeding rate was 0.2 m/min. Unless defined otherwise, the applied UV light intensity was 40 mW/cm$^2$.

**Experiment 2**

***Effects of different partial curing times and different UV intensities during partial curing step on mold repeatability:***

In Fig. 9, the flexible mold repeatability of a final mold obtained after a second curing step is shown depending on different partial curing times and different UV intensities. The inventive UV-R2R system of Example 1 was used with the mold top layer made of PVS and the UV curable material being PUA resin. The conditions of the inventive UV R2R system according to Example 1 were used, wherein the UV intensities as well as the curing times during the second curing step were chosen as follows.

*a) Curing level beyond partial curing and low UV intensity*

A long partial curing time of 6 min and a low UV intensity of about 1.1 mW cm$^2$ resulted in a low flexible mold repeatability even though the surface of the PUA resin was completely cured without leaving any uncured tacky layer on the surface. The mold repeatability was about 40 cycles (see top images of Fig. 9). As shown in the top images of Fig. 9, the surface roughness of the silicone mold changed/deteriorated within 20 cycles and the mold failed at around 40 cycles.

*b) Incomplete partial curing and high UV intensity*

Using a high UV intensity of about 1.4 W/cm$^2$ with incomplete partial curing with a partial curing time of 15 sec curing, resulted in the surface of the printed 3D-patterned PUA microstructure being not completely cured, and the mold suffering from totally being damaged before 30 cycles (see middle images of Fig. 9).

*c) Complete partial curing and low UV intensity*

A low UV intensity and complete partial curing process at 6.6 mW/cm$^2$ and 50 seconds curing was used. As shown in the last image in bottom images of Fig. 9, the mold successfully survived up to 200 cycles without visible damages on the mold and printed microstructures. Hence, it was clearly shown that an appropriate UV intensity and complete partial curing increases the mold repeatability, especially when the two factors are applied simultaneously.

**Experiment 3**

***Partial curing dependent surface roughness (Ra) of PUA:***

The inventive UV R2R system of Example 1 was used with the mold top layer made of PVS and the UV curable material being PUA resin. Before measuring the surface roughness, the partially cured PUA casting was subjected to a second curing step under the UV chamber of 254 nm-wavelength UV light for 3 min at 2 mW cm$^{-2}$, which resulted in

complete surface curing of the 3D-patterned PUA microstructures.

Insufficient partial curing of PUA at 2 minutes or 2.5 minutes at a UV wavelength of 365 nm and a UV intensity of 2 mW/cm$^2$, resulted in a surface roughness Ra of about 6.4 nm or about 6.2 nm; see Fig. 4a.

Curing beyond being partially cured of PUA at 5 minutes or 10 minutes at a UV wavelength of 365 nm and a UV intensity of 2 mW/cm$^2$ resulted in a surface roughness Ra of about 11.8 nm or about 13 nm; see Fig. 4a.

Complete partial curing of PUA at 3 minutes at a UV wavelength of 365 nm and a UV intensity of 2 mW/cm$^2$ using a PVS mold top layer resulted in a surface roughness Ra of about 3.6 nm; see Fig. 4a.

### Example 4

### Partial curing dependent pull-off force (POF) of PUA:

The inventive UV R2R system of Example 1 was used with the mold top layer made of PVS and the UV curable material being PUA resin. Before measuring the pull-off force, the partially cured PUA casting was subjected to a second curing step under the UV chamber of 254 nm-wavelength UV light for 3 min at 2 mW cm$^2$, which resulted in complete surface curing of the 3D-patterned PUA microstructures.

Insufficient partial curing of PUA at 2 minutes or 2.5 minutes at a UV wavelength of 365 nm and a UV intensity of 2 mW/cm$^2$ using a PVS mold top layer resulted in a POF of about 8.9 mN or about 9.4 mN; see Fig. 4b.

Curing beyond being partially cured of PUA at 5 minutes or 10 minutes at a UV wavelength of 365 nm and a UV intensity of 2 mW/cm$^2$ using a PVS mold top layer resulted in a pull-off force POF of about 26.7 mN or about 24 mN; see Fig. 4b.

Complete partial curing of PUA at 3 minutes at a UV wavelength of 365 nm and a UV intensity of 2 mW/cm$^2$ using a PVS mold top layer resulted in a pull-off force POF of about 30.6 mN; see Fig. 4b.

### Example 5

### Enhanced adhesive performance of 3D-patterned microstructures:

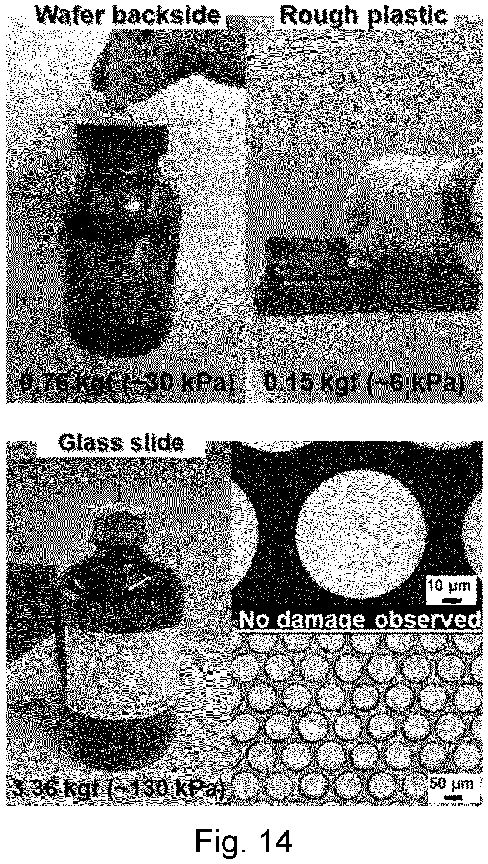

The adhesive performance of the printed 3D-patterned PUA microstructures from the R2R system was tested against smooth and rough surfaces in order to compare their performance with 3D-patterned microstructures made from conventional UV-R2R manufacturing methods; see Fig. 14.

The printed 3D-patterned PUA microstructures (truncated cone-shaped, Str. #1 of Fig. 11a) showed the ability to lift up objects of 0.76 kg and 0.15 kg (about 30 kPa and about 6 kPa), respectively, with contact to the rough silicon wafer backside and the rough plastic (Ra: about 0.7 μm and about 5 μm, respectively). Although the adhesive strengths were tested against rough surfaces, they were higher or comparable to the strengths measured against smooth glass surfaces using the 3D-patterned microstructures fabricated from conventional UV-R2R manufacturing systems. When the 3D-patterend PUA microstructures were tested against a smooth glass surface, the microstructures were able to lift up an object of about 3.36 kg (about 130 kPa).

### Example 6

### Enhanced flexible mold repeatability:

### a) Truncated cone-shaped mold top layer

A PVS mold top layer was made using the inking process. The micrometer-sized cavities in the PVS mold top layer were truncated cone-shaped, resulting in a 3D-patterned microstructure having truncated cone-shaped tips, as shown in Fig. 11a. For UV-R2R printing, the inventive system of Example 1 was applied using PUA as the UV curable material.

As shown in Fig. 11a, the flexible PVS mold demonstrated a mold repeatability of at least 1,000 cycles. The 3D-patterned microstructures shown in Fig. 11a could hence be printed up to 1,000 cycles.

### b) Mushroom-shaped mold top layer

A PVS mold top layer was made using the two-photon polymerization. The micrometer-sized cavities in the PVS mold top layer were mushroom-shaped, resulting in a 3D-patterned microstructure having mushroom-shaped tips, as shown in Fig. 11b. For UV-R2R printing, the inventive system of Example 1 was applied using PUA as the UV curable material.

As shown in Fig. 11b, the flexible PVS mold demonstrated a mold repeatability of at least 1,000 cycles. The 3D-patterned microstructures shown in Fig. 11b could hence be printed up to 1,000 cycles.

*c) PFPE mold top layer*

A PFPE mold top layer was made using the two-photon polymerization. The micrometer-sized cavities in the PFPE mold top layer were mushroom-shaped, resulting in a 3D-patterned microstructure having mushroom-shaped tips, as shown in Fig. 12. For UV-R2R printing, the inventive system of Example 1 was applied using PUA as the UV curable material.

As shown in Fig. 12, the flexible PFPE mold demonstrated a mold repeatability of at least 600 cycles. The 3D-patterned microstructures shown in Fig. 12 could hence be printed up to 600 cycles. In comparison thereto, using a conventional UV R2R setup showed reduced mold repeatability, see Comparative Example 2.

***Example 7***

***Pull-Off Force Results at replication cycle 1,000***

*a) Truncated cone-shaped mold top layer*

The 3D-patterned microstructure having truncated cone-shaped tips described in Example 6a) was tested for its pull-off force performance. As shown in Fig. 11c, the pull-off force thereof (Str.#1) reached 30 mN at replication cycle 1, and only slightly decreased to about 25 mN at replication cycle 1,000.

b) *Mushroom-shaped mold top layer*

The 3D-patterned microstructure having mushroom-shaped tips described in Example 6b) was tested for its pull-off force performance. As shown in Fig. 11c, the pull-off force thereof (Str.#2) reached 50 mN at replication cycle 1, and only slightly decreased to about 45 mN at replication cycle 1,000.

**List of references**

1    Pressing (squeezing) roller
2    Molding roller
3    UV chamber
4    Demolding roller

10    Pressing (squeezing) roller
20    Molding roller
30    UV chamber for first curing step
40    Demolding roller
50    UV system for second curing step

**Claims**

**1.** A method of roll-to-roll (R2R) manufacturing of a 3D-patterned microstructure, the method comprising the steps of:

a) Providing a UV-curable material, the UV-curable material being castable;
b) Providing a mold layer comprising a microstructured mold top layer, the microstructured mold top layer being flexible;
c) Filling at least one part of the microstructured mold top layer with the UV-curable material, thereby providing a raw casting of the mold layer, the raw casting comprising the UV-curable material;
d) Subjecting the raw casting to a first curing step at a UV intensity of 10,000 mW/cm$^2$ or less, thereby providing a partially cured casting having a microstructured surface, wherein at least one part of the microstructured surface is not fully cured;
e) Removing the partially cured casting from the mold layer, thereby providing a removed partially cured casting;

f) Subjecting the removed partially cured casting to a second curing step, thereby providing a fully cured casting having a microstructured surface, wherein a total of the microstructured surface is fully cured.

2. The method according to claim 1, wherein

the UV-curable material has a Young's modulus of about 100 GPa or less, preferably wherein the UV-curable material has a Young's modulus in the range of from about 0.1 MPa to about 100 MPa, preferably from about 1 MPa to about 10 MPa, more preferably from about 2 MPa to about 6 MPa, more preferably from about 2.5 MPa to about 5 MPa, more preferably of from about 2 MPa to about 4.5 MPa, more preferably from about 2 MPa to about 4 MPa, more preferably from about 2.5 MPa to about 3.5 MPa, and even more preferably from about 2.7 MPa to about 3.2 MPa, even more preferably wherein the UV-curable material has a Young's modulus of about 9.4 MPa, about 3.2 MPa, about 2.7 MPa, or about 1.8 MPa, preferably of about 3.2 MPa; and/or wherein the UV-curable material has an elongation at break value of 900 % or less, preferably wherein the UV-curable material has an elongation at break value in the range of from about 900 % to about 10 %, preferably from about 260 % to about 90 %, more preferably of from about 200 % to about 150 %, more preferably of from about 180 % to about 150 %, and even more preferably of from about 170 % to about 160 %, even more preferably wherein the UV-curable material has an elongation at break value of about 250 %, about 166 %, about 165 %, or about 93 %, preferably of about 166 %.

3. The method according to claim 1 or 2, wherein

the UV-curable material comprises an acrylic resin, preferably wherein the acrylic resin is aliphatic, and/or wherein the UV-curable material comprises polyurethane acrylate (PUA), silicone, polyvinylsiloxane (PVS), perfluoropolyether (PFPE), polydimethyl siloxane (PDMS), synthetic rubber, natural rubber, liquid crystal elastomer, butyl rubber, biological elastomer, protein, shape memory polymer, conductive polymer, magnetorheological elastomer, zwitterionic polymer, styrene-ethylene-butylene-styrene (SEBS), foam elastomer, and/or composite polymer comprising micrometer or nanometer-sized particle, colloid, fiber, tube, sheet, wire, fabric, bubble, and/or clay.

4. The method according to any one of claims 1 to 3, wherein
the UV-curable material further comprises a photoinitiator, preferably wherein the photoinitiator is present in an amount of from about 1 wt% to about 8 wt%, more preferably in an amount of from about 2 wt% to about 5 wt%, more preferably in an amount of from about 3 wt% to about 4 wt%, and even more preferably of about 3 wt%, based on a total mass of the UV-curable material; and/or wherein the photoinitiator is selected from the group consisting of 2-hydroxy-2-methylpropiophenone, and/or type I photoinitiator comprising 1-Hydroxycyclohexyl phenyl ketone, diphenyl(2,4,6-trimethylbenzoyl)phosphine oxide, and/or 4-Hydroxybenzophenone.

5. The method according to any one of claims 1 to 4, wherein

the mold layer further comprises a bottom layer and at least one intermediate layer, the at least one intermediate layer being situated between the microstructured mold top layer and the bottom layer;
preferably wherein the bottom layer is a PET layer, and wherein the at least one intermediate layer comprises an adhesive layer, wherein the adhesive layer comprises a double-sided tape; and/or
wherein the microstructured mold top layer has a height of 5000 $\mu$m or less; and/or
wherein the microstructured mold top layer is not metal-based.

6. The method according to any one of claims 1 to 5, wherein

the microstructured mold top layer comprises micrometer-sized cavities having a mean cavity depth, a mean cavity upper diameter, and a mean cavity lower diameter;
wherein the mean cavity upper diameter is a mean diameter of an upper end of the cavity;
wherein the mean cavity lower diameter is a mean diameter of a lower end of the cavity; and
wherein the cavities are uniformly arranged to one another with a mean center to center distance of 5000 $\mu$m or less with hexagonal array, preferably 100 $\mu$m or less;
preferably wherein the mean cavity depth is about 100 $\mu$m or less, preferably about 60 $\mu$m;
preferably wherein the mean cavity upper diameter is about 100 $\mu$m or less, preferably about 50 $\mu$m;
preferably wherein the mean cavity lower diameter is about 150 $\mu$m or less, preferably about 70 $\mu$m; and/or
preferably wherein the cavities are mushroom-shaped, cylindrical, truncated cone-shaped, wedge-shaped, flap-shaped, or combinations thereof, preferably mushroom-shaped or truncated cone-shaped.

7.  The method according to any one of claims 1 to 6, wherein

     the microstructured mold top layer has a UV transmission of about 80 % or less, preferably of 70 % or less, more preferably of about 60 % or less, more preferably of about 50 % or less, more preferably of about 40 % or less, more preferably of about 30 % or less, more preferably of about 20 % or less, more preferably of about 10 % or less, more preferably of about 5 % or less, and even more preferably of 2 % or less; and/or
     wherein the microstructured mold top layer has an oxygen transmission rate of 100 $cc/m^2/24hrs$ or more, preferably of 5,000 $cc/m^2/24hrs$ or more, preferably of 10,000 $cc/m^2/24hrs$ or more, more preferably of 25,000 $cc/m^2/24hrs$ or more, more preferably of 50,000 $cc/m^2/24hrs$ or more, more preferably of 75,000 $cc/m^2/24hrs$ or more, and even more preferably of 100,000 $cc/m^2/24hrs$ or more.

8.  The method according to any one of claims 1 to 7, wherein

     the microstructured mold top layer comprises polyvinylsiloxane (PVS), polydimethylsiloxane (PDMS), polyurethane acrylate (PUA), butyl rubber, liquid crystal elastomer, fluorinated silicone, silicone rubber, and/or perfluoropolyether (PFPE), preferably polyvinylsiloxane (PVS); and/or
     wherein the microstructured mold top layer is opaque.

9.  The method according to any one of claims 1 to 8, wherein

     in step c) the at least one part of the microstructured mold top layer is filled with the UV-curable material by pressing the UV-curable material onto the microstructured mold top layer with a pressure of 0.01 MPa or more, thereby filling at least one part of the cavities of the microstructured mold top layer; preferably
     wherein a PET layer is situated on top of the UV-curable material and the pressure is applied to the PET layer situated on top of the UV-curable material, thereby filling at least one part of the cavities of the microstructured mold top layer with the UV-curable material.

10. The method according to any one of claims 1 to 9, wherein

     the UV intensity during the first curing step is about 50 $mW/cm^2$ or less, preferably about 30 $mW/cm^2$ or less, preferably about 10 $mW/cm^2$ or less, preferably about 8 $mW/cm^2$ or less, preferably about 7 $mW/cm^2$ or less, preferably about 5 $mW/cm^2$ or less, preferably about 3 $mW/cm^2$ or less, preferably about 2 $mW/cm^2$ or less, preferably about 1.5 $mW/cm^2$ or less; even more preferably wherein the UV intensity during the first curing step is about 6.6 $mW/cm^2$, about 2 $mW/cm^2$, or about 1.4 $mW/cm^2$; and/or
     wherein the first curing step is carried out at a UV wavelength of from about 320 nm to about 390 nm, preferably of from about 340 nm to about 380 nm, preferably of from about 350 nm to about 375 nm, more preferably of from about 360 nm to about 370 nm, and even more preferably of about 365 nm.

11. The method according to any one of claims 1 to 10, wherein

     the UV intensity during the second curing step is about 1.5 $mW/cm^2$ or more, preferably about 2 $mW/cm^2$ or more, preferably about 4 $mW/cm^2$ or more, preferably about 8 $mW/cm^2$ or more, preferably about 10 $mW/cm^2$ or more, preferably about 20 $mW/cm^2$ or more, preferably about 40 $mW/cm^2$ or more, more preferably about 100 $mW/cm^2$ or more, and even more preferably about 1 $mW/cm^2$ or more; and/or
     wherein the second curing step is carried out at a UV wavelength of from about 320 nm to about 220 nm, preferably of from about 300 nm to about 240 nm, more preferably of from 260 nm to about 250 nm, and even more preferably of about 254 nm.

12. The method according to any one of claims 1 to 11, wherein
     a UV wavelength applied during the second curing step is smaller than a UV wavelength applied during the first curing step.

13. The method according to any one of claims 1 to 12, wherein
     at least about 50% of the microstructured surface of the partially cured casting is uncured, preferably at least about 70%, preferably at least about 80%, preferably at least about 90%, and more preferably at least about 95%.

14. A 3D-patterned microstructure obtained by the method according to any one of claims 1 to 13, preferably wherein the 3D-patterned microstructure is selected from the group consisting of an adhesive 3D-patterned microstructure, a frictional 3D-patterned microstructure, a gripping 3D-patterned microstructure, a closure device comprising the 3D-patterned microstructure, an optically active 3D-patterned microstructure, an air/fluid drag-control device comprising the 3D-patterned microstructure, an antifouling 3D-patterned microstructure, an anti-fogging 3D-patterned microstructure, a super-wetting 3D-patterned microstructure, a thermally insulating 3D-patterned microstructure, a thermally conductive 3D-patterned microstructure, a skin-adhesive 3D-patterned microstructure, an electrically insulating 3D-patterned microstructure, an electrically conductive 3D-patterned microstructure, an actuator device comprising the 3D-patterned microstructure, a sensor device comprising the 3D-patterned microstructure, a flexible circuit device comprising the 3D-patterned microstructure, a battery device comprising the 3D-patterned microstructure, and/or a non-wetting 3D-patterned microstructure.

15. Use of a 3D-patterned microstructure manufactured according to the method of any one of claims 1 to 13 as at least one of a synthetic dry adhesive comprising a tape, a biomimetic adhesive comprising a gecko-inspired adhesive, a high gripping tape or surface, a non-slip tape or surface, a skin/tissue-adhesive tape or surface, a skin/tissue-gripping tape or surface, a closure tape or surface, a non-wetting tape or surface, a liquid-repellent tape or surface, a liquid-repellent adhesive tape or surface, a self-cleaning tape or surface, an anti-reflection coating, a drag reduction coating, an anti-fouling coating, an anti-fogging coating, a non-icing coating, a flexible electronic device, an optical device, a ciliated actuator device, an actuator device, a sensor device, a structured flexible battery, a solar cell layer, and/or a robotic device.

16. An apparatus for manufacturing a 3D-patterned microstructure, the apparatus being configured to carry out the method according to any one of claims 1 to 13, the apparatus being a printing unit of an R2R UV-curing manufacturing system, comprising:

a pressing roller, a molding roller comprising a mold layer on an outer surface of the molding roller, and a demolding roller arranged in a series one after another;
a first UV curing system being attached to the molding roller, or being arranged at the molding roller, and being configured to carry out a first curing step at a UV intensity of 10,000 mW/cm$^2$ or less;
a second UV curing system being attached to the demolding roller, or being arranged after the demolding roller, the second UV curing system being configured to carry out a second curing step;
the pressing roller and the molding roller being arranged to one another in a distance configured to press a UV-curable material onto the mold layer with a pressure of 1 MPa or more; and
the molding roller and the demolding roller being arranged to one another in an angle configured to provide a demolding angle of at least about 80 degrees, preferably 90 degrees.

Fig. 1a

Fig. 1b

Fig. 2

Fig. 3

Fig. 4a

Fig. 4b

Fig. 5

Cavity lower diameter = Tip upper diameter

Cavity depth = Tip height

Cavity upper diameter = Tip lower diameter

Fig. 6a

Fig. 6b

Fig. 6c

Fig. 7a

Fig. 7b

Fig. 7c

(i) PDMS resin

Patterned Si wafer

(ii)

Pillar-shaped PDMS

(iii) *Dipping*

PVS resin

(iv) *Contacting*

Smooth Si wafer

(v)

(vi)

Silanized

# Fig. 8

Fig. 9

Fig. 10

Fig. 11a

Fig. 11b

Fig. 11c

1.4 W cm$^{-2}$, 0.2 m min$^{-1}$ (Complete curing with high UV intensity)
40 mW cm$^{-2}$, 0.2 m min$^{-1}$ (Incomplete curing with low UV intensity)

Fig. 12

Fig. 13a

Fig. 13b

Fig. 13c

Fig. 14

Europäisches
Patentamt

European
Patent Office

Office européen
des brevets

# EUROPEAN SEARCH REPORT

Application Number

EP 22 20 0726

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 106 444 275 A (SHENZHEN INST OF ADV TECH CAS) 22 February 2017 (2017-02-22) | 1,3,7-15 | INV. G03F7/00 |
| Y | * paragraphs [0006] - [0013] * <br> * paragraphs [0057] - [0069]; figures 1,6 * <br> * paragraph [0097] * <br> * paragraph [0170] * <br> * paragraphs [0181] - [0184] * | 2,4-6,16 | B29C41/00 B29C43/00 B82Y40/00 |
| X | YI HOON ET AL: "Continuous and Scalable Fabrication of Bioinspired Dry Adhesives via a Roll-to-Roll Process with Modulated Ultraviolet-Curable Resin", APPLIED MATERIALS & INTERFACES, vol. 6, no. 16, 27 August 2014 (2014-08-27), pages 14590-14599, XP093033310, US ISSN: 1944-8244, DOI: 10.1021/am503901f | 1,2,5-8, 10-12, 14,15 | |
| Y | * Introduction; figure 1 * <br> * Results and Discussion; figure 3b * | 2,5,6 | TECHNICAL FIELDS SEARCHED (IPC) G03F B29C B82Y |
| Y | CHIDAMBARAM NACHIAPPAN ET AL: "High fidelity 3D thermal nanoimprint with UV curable polydimethyl siloxane stamps", JOURNAL OF VACUUM SCIENCE, AMERICAN INSTITUTE OF PHYSICS, 2 HUNTINGTON QUADRANGLE, MELVILLE, NY 11747, vol. 34, no. 6, 19 August 2016 (2016-08-19), XP012210537, ISSN: 2166-2746, DOI: 10.1116/1.4961250 [retrieved on 2016-08-19] * Section III, B; figure 4 * | 16 | |

-/--

The present search report has been drawn up for all claims

| Place of search | Date of completion of the search | Examiner |
|---|---|---|
| Munich | 21 March 2023 | van Toledo, Wiebo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

Application Number

EP 22 20 0726

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2009/046362 A1 (GUO LINGJIE JAY [US] ET AL) 19 February 2009 (2009-02-19)<br>* paragraph [0039]; figure 15 *<br>* paragraph [0100] * | 16 | |
| Y | JP 2009 262513 A (KONICA MINOLTA OPTO INC) 12 November 2009 (2009-11-12)<br>* paragraphs [0021] - [0033]; figure 1 * | 16 | |
| Y | US 2009/297724 A1 (WEBER EILEEN M [US]) 3 December 2009 (2009-12-03)<br>* paragraph [0006] *<br>* paragraphs [0030] - [0031] * | 4 | |
| Y | CN 111 175 869 A (SHENZHEN LOCHN OPTICS TECH CO LTD) 19 May 2020 (2020-05-19)<br>* paragraph [0026]; figure 2 * | 5 | |
| Y | WO 2017/059745 A1 (UNIV QINGDAO TECHNOLOGICAL [CN])<br>13 April 2017 (2017-04-13)<br>* page 9, paragraph 81; figure 4 * | 5 | **TECHNICAL FIELDS SEARCHED (IPC)** |
| A | BAE WON-GYU ET AL: "Instantly switchable adhesion of bridged fibrillar adhesive via gecko-inspired detachment mechanism and its application to a transportation system",<br>NANOSCALE,<br>vol. 5, no. 23,<br>1 January 2013 (2013-01-01), page 11876,<br>XP093033367,<br>United Kingdom<br>ISSN: 2040-3364, DOI: 10.1039/c3nr02008h<br>* 2. Results;<br>figures 1-3 * | 16 | |

The present search report has been drawn up for all claims

| Place of search | Date of completion of the search | Examiner |
|---|---|---|
| Munich | 21 March 2023 | van Toledo, Wiebo |

EPO FORM 1503 03.82 (P04C01)

## ANNEX TO THE EUROPEAN SEARCH REPORT
## ON EUROPEAN PATENT APPLICATION NO.

EP 22 20 0726

This annex lists the patent family members relating to the patent documents cited in the above-mentioned European search report.
The members are as contained in the European Patent Office EDP file on
The European Patent Office is in no way liable for these particulars which are merely given for the purpose of information.

21-03-2023

| Patent document cited in search report | | Publication date | Patent family member(s) | | Publication date |
|---|---|---|---|---|---|
| CN 106444275 | A | 22-02-2017 | NONE | | |
| US 2009046362 | A1 | 19-02-2009 | US | 2009046362 A1 | 19-02-2009 |
| | | | WO | 2008124180 A1 | 16-10-2008 |
| JP 2009262513 | A | 12-11-2009 | NONE | | |
| US 2009297724 | A1 | 03-12-2009 | AR | 073449 A1 | 10-11-2010 |
| | | | TW | 201002789 A | 16-01-2010 |
| | | | US | 2009297724 A1 | 03-12-2009 |
| | | | US | 2015353758 A1 | 10-12-2015 |
| | | | US | 2018340093 A1 | 29-11-2018 |
| | | | US | 2019322897 A1 | 24-10-2019 |
| | | | US | 2022169889 A1 | 02-06-2022 |
| CN 111175869 | A | 19-05-2020 | NONE | | |
| WO 2017059745 | A1 | 13-04-2017 | CN | 105159029 A | 16-12-2015 |
| | | | WO | 2017059745 A1 | 13-04-2017 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **ANTHONY P. RUSSELL et al.** *Integrative and Comparative Biology,* 2019, vol. 59 (1), 101-116